# EUROPÄISCHE PATENTSCHRIFT

(11) **EP 2 812 915 B1**
(45) Veröffentlichungstag und Bekanntmachung des Hinweises auf die Patenterteilung: **07.07.2021**
(21) Anmeldenummer: 13709538.6
(22) Anmeldetag: 17.01.2013
(51) Int. Cl.: H01L 21/67, H01L 21/677

(54) **SUBSTRATBEARBEITUNGSANLAGE**
SUBSTRATE TREATMENT SYSTEM
INSTALLATION DE TRAITEMENT DE SUBSTRAT

(30) Priorität: 06.02.2012 DE 102012100929
(43) Veröffentlichungstag der Anmeldung: 17.12.2014
(60) Teilanmeldung: 21177601.8
(73) Patentinhaber: Meyer Burger (Germany) GmbH, 09337 Hohenstein-Ernstthal (DE)
(72) Erfinder: MAI, Joachim, 04603 Nobitz (DE); KEHR, Mirko, 09439 Amtsberg (DE)
(74) Vertreter: Steiniger, Carmen
(86) Internationale Anmeldenummer: PCT/IB2013/050414
(87) Internationale Veröffentlichungsnummer: WO 2013/118003

(56) Entgegenhaltungen:
- EP-A2- 1 749 901
- WO-A1-03/100848
- WO-A1-2011/003484
- WO-A1-2011/055482
- DE-A1-102010 017 497
- JP-A- H04 154 145
- JP-A- 2003 142 393
- US-A- 5 788 448
- US-A1- 2011 278 205
- US-A1- 2011 313 565

## Beschreibung

Die vorliegende Erfindung betrifft eine Substratbearbeitungsanlage gemäß Anspruch 1.

Im Stand der Technik sind Durchlaufbeschichtungsanlagen bekannt, die beispielsweise zur Massenproduktion von Solarzellen eingesetzt werden. Für die Beschichtung werden mehrere, beispielsweise 42, Solarzellenwafer auf einer Trägervorrichtung in einer Ebene platziert und in der Durchlaufanlage während eines kontinuierlichen Durchlaufes durch diese Anlage beschichtet. Einzelne Bearbeitungsbereiche werden dabei beispielsweise durch Gasvorhänge voneinander isoliert. Die Weiterentwicklung in der Solarzellentechnologie führt regelmäßig auch zu erhöhten Anforderungen an die Anlagentechnik, beispielsweise bezüglich der Prozessreinheit in den Substratbearbeitungsanlagen. Die Erfüllung dieser wachsenden Anforderungen ist mit herkömmlichen Durchlaufanlagen problematisch.

Im Stand der Technik sind auch verschiedene Typen von Substratbearbeitungsanlagen bekannt, die erhöhte Reinheitsanforderungen erfüllen. Ein Typ solcher Substratbearbeitungsanlagen ist ein Batch-Vertikal-Ofen, der aus der Mikroelektronik-Industrie bekannt ist. Bei dem Batch-Ofen kommt als Trägervorrichtung für Substrate ein Boot zum Einsatz. In das Boot wird eine Vielzahl von Substraten, beispielsweise 150 Wafer, eingebracht. Die Substrate stehen in dem Boot parallel zueinander und voneinander beabstandet. In einigen Batch-Öfen ist das Boot in einem Boottransportraum durch einen Boottransportmechanismus horizontal und vertikal bewegbar und in die Prozesskammer, die auch als Ofenrohr bezeichnet wird, einbringbar. Dabei wird die Prozesskammer bei einigen Öfen vakuumdicht geschlossen. Manche Batch-Öfen weisen gasdichte Verschlusseinrichtungen zwischen dem Substratbelade- und -entladebereich und dem Boottransportraum auf. Problematisch an Batch-Öfen ist, dass diese regelmäßig nur zur thermischen Bearbeitung und nicht zur plasmagestützten Substratbearbeitung geeignet sind. Außerdem hat der Waferstapel in dem Boot eine große thermische Masse, sodass bei Batch-Öfen relativ große Aufheiz- und Abkühlzeiten in Kauf zu nehmen sind.

Ein anderer Anlagentyp ist aus der Druckschrift WO 2011/148924 A1 bekannt. Bei diesem Anlagentyp werden jeweils sechs Wafer parallel zueinander und voneinander beabstandet auf einem Waferträger aufrecht stehend angeordnet. Dieser Waferträger wird aus einer Schleusenkammer durch einen evakuierten Waferträger-Transportraum in quaderförmige Beschichtungskammern gefahren. In den Beschichtungskammern erfolgen plasmagestützte Schichtabscheidungen. Problematisch bei diesem Anlagentyp ist unter anderem, dass gleichzeitig nur sechs Substrate in einer Kammer bearbeitet werden und dass deshalb nur relativ geringe Produktionsgeschwindigkeiten erreicht werden.

Aus der Druckschrift US 2011/0313565 A1 ist eine Vorrichtung zum Be- und Entladen einer Bearbeitungsvorrichtung mit Substraten bekannt. Die Vorrichtung weist eine Lade- und Entladeeinheit, eine Ladeschleuse und eine Prozesskammer auf. In der Lade- und Entladeeinheit werden unter Atmosphärenbedingungen Substrate aus einer von einer Kassettenfördereinrichtung transportierten Kassette mittels einer vakuumbasierten, vor- und zurück bewegbaren Greifeinrichtung entnommen, von der Greifeinrichtung auf ein Förderband nebeneinander abgelegt, von dem Förderband mit einem schienengeführten, Bernoulli-Chucks aufweisenden Substraträgerroboter entnommen und auf einen Substratträger abgelegt. Der Substratträger wird mit einer beispielsweise Rollen- oder Roboter-gestützten Transfereinheit in die Prozesskammer transportiert.

Es ist daher die Aufgabe der vorliegenden Erfindung, eine Substratbearbeitungsanlage vorzuschlagen, die durch die Bereitstellung einer hohen Prozessreinheit qualitativ hochwertige Substratbearbeitungen erlaubt und die dabei auch durch einen großen Substratdurchsatz für eine Massenproduktion geeignet ist.

Die Aufgabe wird durch eine Substratbearbeitungsanlage der eingangs definierten Gattung gelöst, die sich dadurch auszeichnet, dass der Substratbelade- und -entladebereich mit dem Trägertransportbereich durch einen Substratumladebereich mit wenigstens einer Substratumladevorrichtung zum Umladen des wenigstens einen Substrates von wenigstens einer in dem Substratbelade- und -entladebereich vorsehbaren Substratkassette, in welcher Substrate in verschiedenen horizontalen Kassettenebenen der Substratkassette anordenbar sind, auf die wenigstens eine Trägervorrichtung, mit der das wenig stens eine Substrat in einer horizontalen Trägerebene haltbar ist, gekoppelt ist, wobei der Substratumladebereich gegenüber dem Substratbelade- und -entladebereich gasdicht verschließbar ist. Darüber hinaus weist die erfindungsgemäße Substratbearbeitungsanlage wenigstens zwei der Trägervorrichtungen und wenigstens zwei der Trägertransportbereiche auf, zwischen welchen eine Substratumladestation zum Umladen der Substrate von einer der Trägervorrichtungen auf eine andere der Trägervorrichtungen vorgesehen ist, wobei der Substratumladebereich mit Inertgas befüllbar ist oder mit Vakuum oder mit einem reaktiven Gas gefüllt ist.

Die erfindungsgemäße Substratbearbeitungsanlage weist also einen Substratbelade- und -entladebereich auf, in welchen Substratkassetten eingebracht und aus diesem entnommen werden können. Dabei kann der Substratbelade- und -entladebereich sowohl zum Beladen als auch zum Entladen vorgesehen sein. Es können aber auch mehrere, voneinander getrennte Substratbelade- und -entladebereiche vorgesehen sein, wobei beispielsweise am Anfang einer Durchlaufanlage ein Substratbeladebereich und am Ende der Durchlaufanlage ein Substratentladebereich vorgesehen ist. In den Substratkassetten sind mehrere flächige Substrate parallel zueinander in verschiedenen Kassettenebenen in horizontaler Lage angeordnet.

Mit dem Substratbelade- und -entladebereich ist ein Substratumladebereich gekoppelt. Dabei ist ein gasdichter Verschluss zwischen dem Substratbelade- und -entladebereich und dem Substratumladebereich vorgesehen, welcher für Verunreinigungen in der Atmosphäre ein Hindernis darstellt, das deren Verschleppung in die Prozesskammern verhindert und so eine erhöhte Reinheit in der Substratbearbeitungsanlage bewirkt.

In dem Substratumladebereich werden die Substrate aus der Substratkassette auf die in dem Trägertransportbereich vorgesehene Trägervorrichtung oder von der Trägervorrichtung in die Substratkassette umgeladen. Je nach Substratgröße finden unterschiedlich viele Substrate auf der Trägervorrichtung Platz. Im Extremfall sehr großer Substrate, mit Abmessungen von mehr als fünf Dezimetern, kann auch nur ein Substrat auf der Trägervorrichtung vorgesehen sein.

Durch den gasdichten Verschluss zwischen dem Substratumladebereich und dem Substratbelade- und -entladebereich bildet der Substratumladebereich eine Art Schleuse zwischen dem Substratbe- und -entladebereich und dem Trägertransportbereich. Außerdem gestattet der gasdichte Verschluss den Betrieb des Substratumladebereiches bei einem anderen Druck als dem Druck in dem Substratbelade- und -entladebereich. Dadurch können in dem Substratumladebereich verschiedene Maßnahmen realisiert werden, die der Erhöhung der Reinheit in der Substratbearbeitungsanlage dienlich sind. Beispielsweise können Spülzyklen in dem Substratumladebereich durchgeführt werden.

In der erfindungsgemäßen Substratbearbeitungsanlage ist der Substratumladebereich mit Inertgas befüllbar. Durch die Inertgasfüllung herrscht in dem Substratumladebereich eine definierte und saubere Atmosphäre, die hauptsächlich durch die Reinheit des verwendeten Inertgases bestimmt wird. Durch die chemische Inaktivität des Inertgases können Oberflächenveränderungen an den Substraten vermieden werden. Beispielsweise bei Solarzellsubstraten können dadurch hohe Oberflächenqualitäten, die beispielsweise an großen Ladungsträgerlebensdauern messbar sind, erreicht werden. Alternativ kann der Substratumladebereich jedoch auch mit Vakuum oder mit einem reaktiven Gas, beispielsweise mit Formiergas, gefüllt sein.

Bei einer besonders bevorzugten Ausbildung der erfindungsgemäßen Substratbearbeitungsanlage weist die Trägervorrichtung in der Trägerebene in Substratträgerzeilen und Substratträgerspalten angeordnete Substratnester auf und die Trägervorrichtung ist in Substratträgerzeilenrichtung und/oder in Substratträgerspaltenrichtung bewegbar. Vor allem bei der verbreiteten Verwendung quadratischer Substrate wird durch die Anordnung in Zeilen und Spalten die zur Verfügung stehende Fläche der Trägervorrichtung gut ausgenutzt, sodass eine hohe Produktivität erreichbar ist. Die lineare Anordnung in Zeilen und Spalten ist auch besonders einfach, sodass in der Substratumladevorrichtung vorgesehene Transportmechaniken für die Substrate zum Erreichen der Substratnester in den Substratträgerzeilen und Substratträgerspalten entsprechend einfach aufgebaut sein können. Die orthogonale Anordnung von Substratträgerzeilen und Substratträgerspalten bedingt rechteckige Trägervorrichtungen, die vorzugsweise für lineare Bewegungen in der Substratträgerzeilenrichtung und/oder der Substratträgerspaltenrichtung vorgesehen sind. Bei Durchlaufanlagen erfolgt der Substratträgertransport regelmäßig nur in einer Richtung, das heißt entweder in der Substratträgerzeilenrichtung oder in der Substratträgerspaltenrichtung. Bei Clusteranlagen, bei denen mehrere Bearbeitungsmodule um einen Substratumladebereich herum in der Substratträgerzeilenrichtung und Substratträgerspaltenrichtung vorhanden sind, ist die Trägervorrichtung in zwei Richtungen, das heißt in der Substratträgerzeilenrichtung und in der Substratträgerspaltenrichtung, bewegbar. Die Substratnester bewirken eine sichere Lage der Substrate auf der Trägervorrichtung mit seitlicher Führung der Substrate, sodass die Substrate bei Bewegungen der Trägervorrichtung nicht verrutschen.

Gemäß einer vorteilhaften Ausbildung der erfindungsgemäßen Substratbearbeitungsanlage weist die Substratumladevorrichtung über dem Trägertransportbereich eine parallel zur Trägervorrichtung vorsehbare Substratablageebene auf, von welcher die Trägervorrichtung ganzflächig, zeilen- oder spaltenweise mit Substraten bestückbar ist. Die Substratablageebene ist horizontal orientiert und ist über der Trägervorrichtung vorgesehen. Die Substratablageebene ist ein günstiges Hilfsmittel, welches eine Ablage und Ausrichtung der Substrate auf eine exakte Position auf der Trägervorrichtung erlaubt. Von der Substratablageebene aus ist eine einfache und schnelle Bestückung der Trägervorrichtung möglich.

Entsprechend einer günstigen Ausführungsform der erfindungsgemäßen Substratbearbeitungsanlage weist die Substratumladevorrichtung wenigstens eine Umladebrücke oder einen Umladearm auf, die bzw. der sich parallel wenigstens einer Substratträgerzeile oder Substratträgerspalte der Trägervorrichtung zum Be- und Entladen dieser Substratträgerzeile oder Substratträgerspalte mit wenigstens einem Substrat erstreckt. Die Umladebrücke bzw. der Umladearm sind vorzugsweise in der Substratablageebene vorgesehen bzw. in diese einbringbar und aus dieser herausbringbar. Mit Hilfe der Umladebrücke oder des Umladearmes können alle Substratnester mittels der Substratumladevorrichtung erreicht werden. Mit der Umladebrücke oder dem Umladearm können alle Substratträgerzeilen oder Substratträgerspalten der Trägervorrichtung nacheinander angefahren werden, oder es kann auch mit mehreren Umladebrücken oder Umladearmen parallel an mehreren Substratträgerzeilen oder Substratträgerspalten der Trägervorrichtung gearbeitet werden.

Die Adressierung der unterschiedlichen Substratträgerzeilen bzw. Substratträgerspalten kann auf unterschiedliche Weise erfolgen. In einem besonders günstigen Beispiel ist die Umladebrücke oder der Umladearm zum Be- und Entladen weiterer Substratträgerzeilen oder Substratträgerspalten der Trägervorrichtung längs einer Substratträgerspaltenrichtung und/oder längs einer Substratträgerzeilenrichtung verfahrbar.

Vorzugsweise weist die Substratumladevorrichtung wenigstens eine berührungslose, Substrat-Handhabungsvorrichtung, wie beispielsweise eine ultraschallgestützte Zimmermann-Schilp-Handling-Vorrichtung, auf. Derartige Substrat-Handhabungsvorrichtungen sind Handling-Vorrichtungen, die auch extrem dünne Substrate zuverlässig bei geringer Bruchgefahr für die Substrate handhaben können. Dabei können die Substrate zum Beispiel durch ihre Gewichtskraft oder durch beispielsweise eine Unterdruck-Ansaugkraft gegen ein durch Ultraschall erzeugtes Gaspolster gedrückt werden, welches als Abstandshalter zu der Substrat-Handhabungsvorrichtung wirkt. Durch das berührungsfreie Funktionsprinzip treten auf den Substraten vorteilhafterweise keine Handlerabdrücke auf. Des Weiteren sind mit solchen Substrat-Handhabungsvorrichtungen hohe Umladegeschwindigkeiten realisierbar. Im Unterschied zu anderen Handling-Vorrichtungen, wie beispielsweise elektrostatischen Greifern, arbeiten beispielsweise die vorgeschlagenen berührungslosen Substrat-Handhabungsvorrichtungen nicht im Vakuum, sondern sie benötigen eine hohe Gasdichte zur Ausbildung der dem Funktionsprinzip dieser Handler zugrunde liegenden Gaskissen. Die erforderliche Gasdichte ist beispielsweise bei Atmosphärendruck gegeben.

Die Substrate können nach einer bevorzugten Ausgestaltung der Erfindung mittels der Substratumladevorrichtung aus der Substratkassette besonders geeignet entnommen und in diese wieder eingebracht werden, wenn die Substratkassette zur definierten Entnahme und Zurückgabe des jeweils obersten Substrates mit einem Liftsystem gekoppelt ist.

Eine weitere Ausführungsform der erfindungsgemäßen Substratbearbeitungsanlage weist wenigstens zwei Trägervorrichtungsebenen auf, wobei in den Trägervorrichtungsebenen befindliche Trägervorrichtungen unabhängig voneinander bewegbar sind. Durch das Vorhandensein mehrerer Trägervorrichtungsebenen wird die Produktivität der Substratbearbeitungsanlage erhöht. Die einzelnen Trägervorrichtungsebenen können zu mehreren Substratbearbeitungsebenen hinführen. Die mehreren Trägervorrichtungsebenen können aber auch, beispielsweise aus logistischen Gründen, lediglich im Trägertransportbereich der Substratbearbeitungsanlage vorgesehen sein. Bei einer bidirektionalen Trägervorrichtungslogistik kann bei dem Vorhandensein mehrerer Trägervorrichtungsebenen eine Trägervorrichtung einer anderen Trägervorrichtung ausweichen, sodass die Trägervorrichtungen ohne längere Wartezeiten in der Substratbearbeitungsanlage bewegt werden können.

Grundsätzlich kann die erfindungsgemäße Substratbearbeitungsanlage neben den vorgenannten mehreren Trägervorrichtungsebenen auch mehrere Be- und Entladeebenen besitzen.

Es ist besonders günstig, wenn die einzelnen Trägervorrichtungsebenen der Substratbearbeitungsanlage durch wenigstens einen Trägervorrichtungslift miteinander verbunden sind. Mit Hilfe des Trägervorrichtungsliftes kann wenigstens eine Trägervorrichtung in eine andere Trägervorrichtungsebene der Substratbearbeitungsanlage gebracht werden.

Wenn die oben beschriebenen mehreren Trägervorrichtungsebenen nur zum Zwecke des Ausweichens in der Substratbearbeitungsanlage vorgesehen sind, ist es weiter vorteilhaft, wenn der Trägervorrichtungslift wenigstens eine weitere Trägervorrichtungsebene, neben der Trägervorrichtungstransportebene, ausbildet. Dadurch kann auf dem Trägervorrichtungslift eine Trägervorrichtung zwischengelagert werden, während eine andere Trägervorrichtung transportiert wird. In einem anderen Ausführungsbeispiel gibt es wenigstens drei Trägervorrichtungsebenen, das heißt die Haupt-Trägervorrichtungsebene und wenigstens eine darüber und wenigstens eine darunter liegende Trägervorrichtungsebene.

Gemäß einer anderen Weiterbildung weist die erfindungsgemäße Substratbearbeitungsanlage wenigstens zwei mit dem Trägertransportbereich gekoppelte, übereinander angeordnete Prozesskammern auf. Mit den übereinander angeordneten Prozesskammern kann die Produktionsleistung der Substratbearbeitungsanlage vergrößert, beispielsweise verdoppelt, werden. Die Kosten der Substratbearbeitungsanlage erhöhen sich dabei, in Relation zu einer Substratbearbeitungsanlage mit in nur einer Ebene angeordneten Prozesskammern, weniger als die Produktionsleistung. Der Trägertransportbereich ist dabei derart ausgebildet, dass alle Prozesskammern für Trägervorrichtungen erreichbar sind.

In einer vorteilhaften konstruktiven Gestaltung der erfindungsgemäßen Substratbearbeitungsanlage weist der Substratbelade- und -entladebereich einen Kassettenspeicher auf, in welchem wenigstens eine Substratkassette vorsehbar und bei Bedarf mit der Substratumladevorrichtung koppelbar ist. Die Kapazität der Substratkassetten und der Trägervorrichtung stehen nicht immer in einem ganzzahligen Verhältnis zueinander. In einem Beispiel haben die Substratkassetten eine Kapazität von 25 Wafern und die Trägervorrichtung eine Kapazität von 42 Wafern, das heißt, eine zweite Substratkassette kann nicht vollständig auf die Trägervorrichtung entladen werden. Für die übrigen Substrate in der zweiten Substratkassette ist es daher günstig, diese in dem Kassettenspeicher zwischenzulagern und aus dem Kassettenspeicher auf eine andere Trägervorrichtung aufzuladen. In dem Kassettenspeicher kann beispielsweise eine normale, einseitig öffenbare Substratkassette vorgesehen sein und mit der Substratumladevorrichtung gekoppelt werden. Alternativ kann in dem Kassettenspeicher auch eine spezielle Speicherkassette vorgesehen sein. Die spezielle Speicherkassette kann beispielsweise den Vorteil haben, dass sie anders als die Substratkassette zweiseitig für den Substrattransport offen ist.

Es ist besonders von Vorteil, wenn der Kassettenspeicher evakuierbar und/oder mit Inertgas befüllbar ist. Die Substrate werden im Kassettenspeicher während des Produktionsprozesses zwischengelagert. Dabei ist mitunter eine Veränderung der Substrate in den Kassettenspeichern zu beobachten. Solche Effekte können unterdrückt oder zumindest minimiert werden, indem die Kassettenspeicher mit Inertgas gefüllt werden oder evakuiert werden oder die Kassettenspeicher mit Evakuier- und Inertgasbefüllschritten gespült werden.

In einer weiteren konstruktiven Ausgestaltung der erfindungsgemäßen Substratbearbeitungsanlage weist der Trägertransportbereich wenigstens eine Temperiervorrichtung, das heißt wenigstens eine Heizung und/oder eine Kühlung auf. Die Heizung und/oder die Kühlung können aus Gründen der Erhöhung der Temperaturhomogenität der Substrate und/oder zur Erhöhung der Substrataufheiz- oder -abkühlgeschwindigkeit vorgesehen sein.

Entsprechend einer anderen Option der erfindungsgemäßen Substratbearbeitungsanlage weist diese eine Substratwendevorrichtung auf. In der Substratbearbeitungsanlage kann beispielsweise eine zweiseitige Beschichtung von Substraten durchgeführt werden, wobei die Beschichtungen in standardisierten Prozesskammern von einer Substratseite erfolgen. Durch die vorgeschlagene Substratwendevorrichtung können die Substrate gedreht werden, sodass die Vorderseite oder Rückseite der Substrate auf die Bearbeitungsseite der Beschichtungskammern gebracht wird.

Gemäß einer weiteren Ausführungsform der erfindungsgemäßen Substratbearbeitungsanlage ist die Substratwendeeinrichtung eine Substratkassettendrehvorrichtung. Das Wenden einzelner Substrate gestaltet sich in der Praxis relativ aufwändig. Mit der vorgeschlagenen Ausführungsform kann das Substratwenden einfacher realisiert werden, wobei die Substrate zunächst in Substratkassetten umgeladen werden, dann die gesamten Substratkassetten gedreht werden und anschließend die Substrate wieder umgeladen werden.

In der erfindungsgemäßen Substratbearbeitungsanlage ist zwischen wenigstens zwei Trägertransportbereichen der Substratbearbeitungsanlage eine Substratumladestation zum Umladen des wenigstens einen Substrates von einer Trägervorrichtung auf eine andere Trägervorrichtung vorgesehen. Erfindungsgemäß erfolgt der Substrattransport teilweise mit Hilfe der Substratumladestation, wobei die Substrate in unterschiedlichen Anlagenteilen auf verschiedenen Trägervorrichtungen bearbeitet werden. Dies ist beispielsweise dann günstig, wenn in einer Prozesskammer eine Trägervorrichtung benötigt wird, die durch die Substratbearbeitung in dieser Prozesskammer konditioniert ist.

Es ist besonders geeignet, wenn die erfindungsgemäße Substratbearbeitungsanlage eine Substratbrucherkennung und/oder eine Substratbruchbeseitigungsvorrichtung aufweist. Derartige Substratbruchbeseitigungsvorrichtungen können beispielsweise eine einfache Substratbruchabsaugung bzw. auch Roboterarme mit speziellen Greifervorrichtungen sein. Substratbrüche sind nicht vollständig zu vermeiden, sondern sie treten mit einer geringen Wahrscheinlichkeit auf. Dabei kann ein Substratbruch den Produktionsprozess in einer Substratbearbeitungsanlage unter Umständen erheblich stören und große Produktionsausfälle verursachen. Mit der vorgeschlagenen Substratbrucherkennung und der Substratbruchbeseitigungsvorrichtung ist es möglich, einen Substratbruch automatisch zu erkennen und seine Folgen zu beseitigen. Es ist auch schon von Vorteil, wenn nur eine Substratbrucherkennung oder nur eine Substratbruchbeseitigungsvorrichtung vorhanden ist, da damit die Folgen des Substratbruches schneller beseitigt werden können.

In einer speziellen Ausgestaltung der erfindungsgemäßen Substratbearbeitungsanlage ist wenigstens eine der Prozesskammern durch die Trägervorrichtung gegenüber einem Prozessmodul, in dem diese Prozesskammer vorgesehen ist, körperlich abschließbar. In diesem Fall bildet die Trägervorrichtung eine Wand, einen Boden oder eine Seitenwand der Prozesskammer aus. Dies wird dadurch erreicht, dass die Trägervorrichtung mittels der Trägertransportvorrichtung zu der Prozesskammer hin und von der Prozesskammer wieder weg transportiert werden kann.

Vorzugsweise bildet die Vorrichtung einen Boden der Prozesskammer aus. Dabei kann die Trägervorrichtung mittels der Trägertransportvorrichtung bis in einen Bereich unter die Prozesskammer bewegt werden und daraufhin mittels einer Hubvorrichtung vertikal nach oben gegen die Prozesskammer gedrückt werden, um einen geeigneten körperlichen Abschluss der Prozesskammer gegenüber dem die Prozesskammer umgebenden Prozessmodul zu erzielen.

Als Trägertransportvorrichtung kann dabei vorteilhaft ein Rollentransportsystem eingesetzt werden. Alternative Trägertransportvorrichtungen sind z. B. Linearmotortransportsysteme, Gabeltransportsysteme usw.

Die wenigstens eine Prozesskammer enthält gemäß der vorliegenden Erfindung eine oder mehrere Vorrichtungen zur Bearbeitung der Substrate. Bevorzugte Bearbeitungsvorrichtungen sind dabei Vorrichtungen zur Erzeugung von Plasma. Eine derartige Vorrichtung kann z. B. eine planare HF-Elektrode sein, die als Gasdusche ausgeführt ist. In diesem Fall bildet die Trägervorrichtung vorzugsweise die Gegenelektrode einer Parallel-Plattenanordnung. Generell besitzen die erfindungsgemäß eingesetzten Prozesskammern jeweils alle für den Betrieb der verwendeten Bearbeitungsvorrichtungen sowie für die Substratbearbeitung notwendigen Medienversorgungsanschlüsse wie Pumpanschlüsse, elektrische Versorgungsanschlüsse, Gasversorgungsanschlüsse und Anschlüsse zur Versorgung von Temperierungsvorrichtungen usw.

Entsprechend einer weiteren möglichen Ausführung der erfindungsgemäßen Substratbearbeitungsanlage weist diese wenigstens ein Prozessmodul mit jeweils wenigstens einer Prozesskammer auf, wobei zwischen dem wenigstens einen Prozessmodul und dem Trägertransportbereich jeweils ein Transfermodul vorgesehen ist, welches gegenüber dem Prozessmodul und gegenüber dem Trägertransportbereich gasdicht verschließbar ist. Somit ist es möglich, die Substrate in dem Transfermodul optimal auf die nachfolgende Prozessierung in dem Prozessmodul vorzubereiten. Ferner können bereits in dem Prozessmodul bearbeitete Substrate in dem Transfermodul wieder geeignet an die Bedingungen in dem Trägertransportbereich angepasst werden. Hierfür kann in dem Transfermodul eine geeignete Atmosphäre oder auch Vakuum und/oder eine geeignete Temperatur eingestellt werden.

Solche Transfermodule können besonders effektiv genutzt werden, wenn in dem Transfermodul wenigstens zwei Ebenen für Trägervorrichtungen vorgesehen sind. Auf diese Weise kann in den verschiedenen, typischerweise übereinander vorgesehenen Ebenen beispielsweise gleichzeitig oder zeitversetzt eine Trägervorrichtung aus einem angrenzenden Prozessmodul herausgebracht werden, während in einer anderen Ebene des Transfermoduls eine weitere Trägervorrichtung für den Hineintransport in das Prozessmodul vorbereitet wird.

In einem anderen Aufbau besitzt die erfindungsgemäße Substratbearbeitungsanlage wenigstens zwei Prozessmodule mit jeweils wenigstens einer Prozesskammer, wobei jedem Prozessmodul eine eigene Trägervorrichtung zugeordnet ist. Dabei bildet vorzugsweise der Trägertransportbereich einen Trennbereich für die Prozessmodule und einen Austauschbereich für Substrate auf jeweils andere Trägervorrichtungen.

Bevorzugte Ausführungsformen der vorliegenden Erfindung, deren Aufbau, Funktion und Vorteile sollen im Folgenden anhand von Figuren näher erläutert werden, wobei
- Figur 1: schematisch eine Ausführungsform einer Substratbearbeitungsanlage mit drei Prozessmodulen in einer Draufsicht zeigt;
- Figur 2: schematisch einen Querschnitt einer weiteren Ausbildung einer Substratbearbeitungsanlage zeigt;
- Figur 3: schematisch eine Variante einer Substratbearbeitungsanlage mit vier Prozessmodulen, welche als Durchlaufanlage konzipiert ist, in einer Draufsicht zeigt;
- Figur 4: schematisch eine andere Gestaltungsmöglichkeit einer Substratbearbeitungsanlage mit vier Prozessmodulen in einer Draufsicht zeigt;
- Figur 5: schematisch ein Beispiel einer erfindungsgemäßen Substratbearbeitungsanlage mit vier Prozessmodulen in einer Draufsicht zeigt;
- Figur 6: schematisch eine Weiterbildung einer Substratbearbeitungsanlage mit vier Mehrkammerprozessmodulen in einer Draufsicht zeigt;
- Figur 7: schematisch einen Querschnitt eines in der Substratbearbeitungsanlage einsetzbaren Mehrkammerprozessmodules zeigt;
- Figur 8: schematisch einen Querschnitt einer weiteren Ausführungsform eines erfindungsgemäß verwendbaren Mehrkammerprozessmodules zeigt;
- Figur 9: schematisch einen Querschnitt einer Substratbearbeitungsanlage mit einem Mehrkammerprozessmodul zeigt;
- Figur 10: schematisch einen Querschnitt einer weiteren Variante einer Substratbearbeitungsanlage zeigt;
- Figur 11: schematisch einen Querschnitt einer Ausgestaltung einer Substratbearbeitungsanlage zeigt;
- Figur 12: schematisch eine Ausführungsform einer Substratbearbeitungsanlage in einer hohen Ausbaustufe in einer Draufsicht zeigt;
- Figur 13: schematisch eine Ausbildung einer Substratbearbeitungsanlage mit linearen Anreihungen von Prozessmodulen in einer Draufsicht zeigt;
- Figur 14: schematisch eine andere Substratbearbeitungsanlage mit linearen Anreihungen von Prozessmodulen in einer Draufsicht zeigt;
- Figur 15: schematisch eine weitere Ausführungsvariante einer Substratbearbeitungsanlage in einer Draufsicht zeigt;
- Figur 16: schematisch noch eine weitere Substratbearbeitungsanlage in einer Ausführung als Cluster-Substratbearbeitungsanlage in einer Draufsicht zeigt;
- Figur 17: schematisch eine andere Substratbearbeitungsanlage in einer Ausführung als Cluster-Substratbearbeitungsanlage in einer Draufsicht zeigt; und
- Figur 18: schematisch eine Variante einer Substratbearbeitungsanlage mit acht Prozessmodulen in einer Draufsicht zeigt.

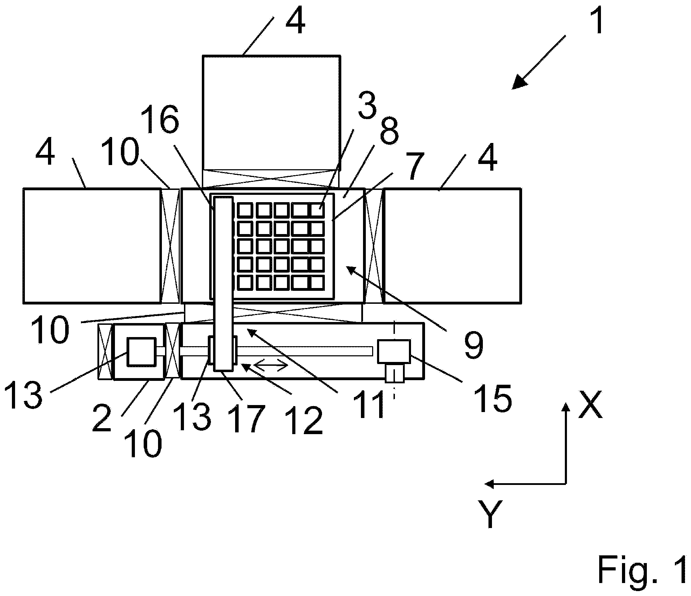

Figur 1 zeigt schematisch eine Draufsicht auf eine Ausführungsform einer Substratbearbeitungsanlage 1. Hier werden Substrate 3 über einen Substratbelade- und -entladebereich 2 in Substratkassetten 13 in die Substratbearbeitungsanlage 1 eingebracht und aus der Substratbearbeitungsanlage 1 nach der Bearbeitung wieder entnommen. An den Substratbelade- und -entladebereich 2 schließt sich ein Substratumladebereich 11 an, der von dem Substratbelade- und -entladebereich 2 durch eine gasdichte Verschlusseinrichtung 10 trennbar ist. In dem Substratumladebereich 11 erfolgt mittels einer Substratumladevorrichtung 12 ein Umladen von Substraten 3 zwischen einer Substratkassette 13 und einer in einem Trägertransportbereich 8 befindlichen Trägervorrichtung 7.

In dem in Figur 1 gezeigten Ausführungsbeispiel ist die Trägervorrichtung 7 ein sogenannter Carrier mit Substratnestern, in welche die Substrate 3 eingelegt werden. Diese Substratnester sind in Substratträgerzeilen und Substratträgerspalten angeordnet. Die Substratträgerzeile mit vorliegend fünf Substratnestern ist von der Substratumladevorrichtung 12 bedienbar, die Substrate 3 in der Substratträgerzeilenrichtung X zu den Substratnestern transportiert. Hierfür weist die Substratumladevorrichtung 12 eine parallel zu einer Substratträgerzeile der Trägervorrichtung 7 verlaufende, oberhalb der Trägervorrichtung 7 angeordnete Umladebrücke 16 bzw. einen entsprechenden Umladearm auf, entlang welchem die Substrate 3 zu den jeweiligen Substratnestern transportiert werden können. Zum Beladen aller Substratträgerzeilen ist die Substratumladevorrichtung 12 in der Substratträgerspaltenrichtung Y bewegbar.

In dem in Figur 1 dargestellten Ausführungsbeispiel weist die Substratumladevorrichtung 12 eine berührungslose Substrat-Handhabungsvorrichtung 17 auf, mit welcher die Substrate 3 aus einer Substratkassette 13 berührungslos entnommen werden können und über die Umladebrücke 16 auf die Trägervorrichtung 7 abgelegt werden können. Als eine solche Substrat-Handhabungsvorrichtung 17 eignet sich beispielsweise eine ultraschallgestützte Zimmermann-Schilp-Handling-Vorrichtung. Es kann jedoch auch jede andere geeignete Substrat-Handhabungsvorrichtung verwendet werden, um die Trägervorrichtung 7 mit Substraten 3 zu beladen bzw. die Substrate 3 wieder von der Trägervorrichtung 7 zu entnehmen.

Der Umladearm bzw. die Umladebrücke 16 kann dafür im Bereich der gasdichten Verschlusseinrichtung 10 unterbrochen sein und einen eigenen Bewegungsantrieb besitzen, wodurch der Substrattransport über die Verschlusseinrichtung 10 hinweg erreicht wird. Eine andere Variante besteht darin, dass der Umladearm bzw. die Umladebrücke 16 erst nach dem Öffnen der Verschlusseinrichtung 10 in den Trägertransportbereich 9 eingefahren wird. In einer weiteren Variante kann auch die Verschlusseinrichtung 10 zwischen dem Trägertransportbereich 9 und dem Substratumladebereich 11 weggelassen werden.

Die Trägervorrichtung 7 kann in dem Trägertransportbereich 9 zu jedem der drei, in dem vorgestellten Ausführungsbeispiel vorgesehenen Prozessmodule 4 bewegt werden. Die Prozessmodule 4 weisen neben einer durch den Trägertransportbereich 9 verlaufenden Trägertransportvorrichtung 8 für die Trägervorrichtung 7 jeweils wenigstens eine Prozesskammer 5 auf. In jeder der Prozesskammern 5 kann beispielsweise eine andere Beschichtung ausgeführt werden.

Jedem Prozessmodul 4 kann auch eine eigene Trägervorrichtung 7 zugeordnet sein. Das ist vorteilhaft, wenn beispielsweise in den weiteren Prozessmodulen 4 der Substratbearbeitungsanlage 1 Bearbeitungen stattfinden, bei denen eine Verschleppung von Verunreinigungen, durch die Trägervorrichtung 7 selbst, nicht ausgeschlossen werden kann. So kann es problematisch sein, wenn zum Beispiel in einem ersten Prozessmodul 4 eine erste Beschichtung unter Zugabe von Dotierstoffen erfolgt und in einem in einem weiteren Prozessmodul 4 durchgeführten folgenden Prozessierungsschritt eine dotierte Schicht abgeschieden werden soll. Der Trägertransportbereich 9 dient dann gleichzeitig als Trennbereich der Prozessmodule 4 und als Austauschbereich der Substrate 3 auf jeweils andere Trägervorrichtungen 7. Die einzelnen Trägervorrichtungen 7 können dann auch unterschiedliche Temperaturen besitzen.

Die Substratbearbeitungsanlage 1 weist ferner eine mit dem Substratumladebereich 11 gekoppelte Kassettendrehvorrichtung 15 auf, mit welcher die Substratkassette 13 gedreht werden kann, sodass beispielsweise nach einer Beschichtung der Vorderseite der Substrate 3 die Substrate 3 gedreht werden können und anschließend die Beschichtung der Substratrückseite erfolgen kann.

Der Trägertransportbereich 9 ist von den Prozessmodulen 4 jeweils durch gasdichte Verschlusseinrichtungen 10 trennbar. Dadurch ist es möglich, die Prozessmodule 4 mit einem anderen Druck als den Substratumladebereich 11 zu betreiben.

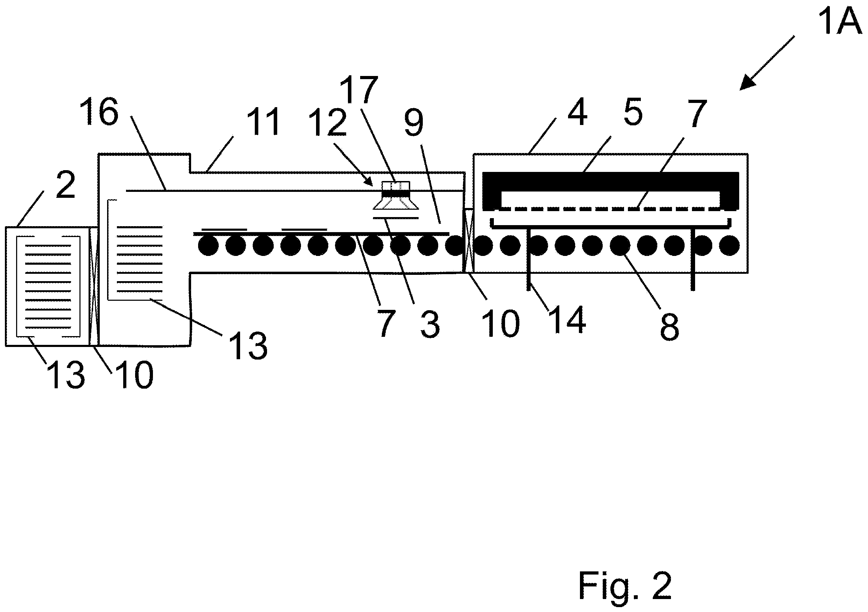

Figur 2 zeigt schematisch einen Querschnitt einer weiteren Variante einer Substratbearbeitungsanlage 1A. Dabei bezeichnen gleiche Bezugszeichen gleiche bzw. ähnliche Elemente wie in der oben beschriebenen Substratbearbeitungsanlage 1 aus Figur 1, weshalb an dieser Stelle auf obige Beschreibung Bezug genommen wird. Gleiches gilt für die Beschreibung der weiteren Figuren.

Im Substratbelade- und -entladebereich 2 befindet sich in dem in Figur 2 dargestellten Funktionsbeispiel eine Substratkassette 13. In dem Substratbelade- und -entladebereich 2 wird nach dem Einbringen der Substratkassette 13 zunächst durch Evakuieren oder Spülen eine saubere und definierte Atmosphäre geschaffen. Wenn in dem Substratbelade- und -entladebereich 2 eine ausreichende Sauberkeit vorhanden ist, wird die gasdichte Verschlusseinrichtung 10 geöffnet und die Substratkassette 13 wird in den Substratumladebereich 11 transferiert. In dem Substratumladebereich 11 werden die Substrate 3 aus der Substratkassette 13 mittels der Substratumladevorrichtung 12 auf die in dem Trägertransportbereich 9 befindliche Trägervorrichtung 7 umgeladen.

In dem in Figur 2 dargestellten Ausführungsbeispiel weist die Substratumladevorrichtung 12 eine berührungslose, ultraschallgestützte Substrat-Handhabungsvorrichtung 17 auf, die an der Umladebrücke 16 geführt ist. Die Substrat-Handhabungsvorrichtung 17 kann, wie oben bereits erwähnt, Substrate 3 berührungslos und mit geringen Kräften greifen. Die Hubkraft wird dabei beispielsweise durch Unterdruck in Unterdruckkanälen erzeugt. Der zum berührungslosen Transport nötige Abstand zu der Substrat-Handhabungsvorrichtung 17 wird durch ein ultraschallerzeugtes Gaspolster sichergestellt. Die gezeigte Substrat-Handhabungsvorrichtung 17 arbeitet prinzipbedingt nicht bei Vakuum, sondern nur bei erhöhtem Druck, beispielsweise bei Atmosphärendruck. Die Substrat-Handhabungsvorrichtung 17 hinterlässt auf den Substraten 3 keine Handlingsabdrücke und ist daher zum Handling von Substraten 3 geeignet, die auf beiden Substratseiten funktionelle Oberflächen aufweisen, für welche hohe Reinheitsanforderungen bestehen. Vorteilhaft ist es, wenn die Substratkassette 13 zur definierten Entnahme oder Zurückgabe des jeweils obersten Substrates 3 mit einem nicht dargestellten Liftsystem verbunden ist.

Die beladene Trägervorrichtung 7 wird durch die Trägertransportvorrichtung 8 in dem Trägertransportbereich 9 zu einem Prozessmodul 4 transportiert. Darin wird die Trägervorrichtung 7 ebenfalls mittels der Trägertransportvorrichtung 8 zu einer Prozesskammer 5 bewegt, wo eine Bearbeitung der Substrate 3 vorgesehen ist. Als Trägertransportvorrichtung 8 wird hier beispielhaft ein Rollentransportsystem verwendet.

In dem dargestellten Ausführungsbeispiel wird in dem Prozessmodul 4 die Trägervorrichtung 7 von einer Hubvorrichtung 14 von der Trägertransportvorrichtung 8 ausgehoben und als Boden der Prozesskammer 5 verwendet. Die Position der Trägervorrichtung 7 bei geschlossener Prozesskammer 5 ist dabei durch eine Strichlinie in dem Prozessmodul 4 in Figur 2 skizziert. Nach der Bearbeitung der Substrate 3 in der Prozesskammer 5 werden die Substrate 3 entgegengesetzt zum Beladeverfahren wieder entladen.

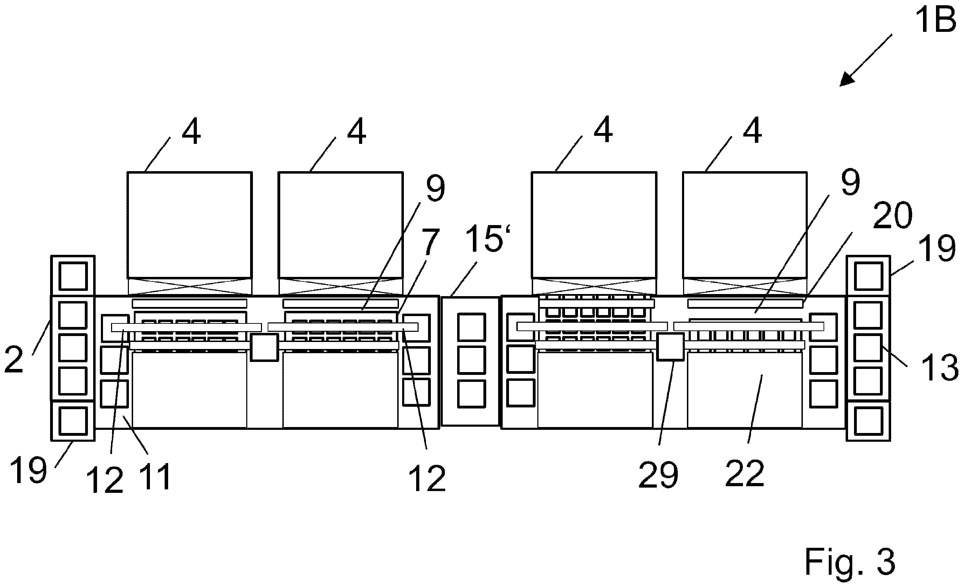

Figur 3 zeigt schematisch eine weitergebildete Version einer Substratbearbeitungsanlage 1B, welche vier Prozessmodule 4 aufweist. Die Substratbearbeitungsanlage 1B ist als Durchlaufanlage konzipiert, bei welcher auf der linken Seite der Darstellung Substratkassetten 13 eingeladen werden. Anschließend durchlaufen die Substrate 3 die Substratbearbeitungsanlage 1B. Abschließend werden auf der rechten Seite der Darstellung die Substratkassetten 13 mit bearbeiteten Substraten 3 entladen.

In der Substratbearbeitungsanlage 1B finden in dem Substratumladebereich 11 zwei Trägervorrichtungen 7 Platz. Mit den Substratumladevorrichtungen 12 ist ein Substrattransport sowohl zwischen einer Substratkassette 13 und einer Trägervorrichtung 7 als auch ein Substrattransport zwischen beiden Trägervorrichtungen 7 möglich. Zwischen den beiden Trägertransportbereichen 9 ist eine Substratkassettendrehvorrichtung 15' angeordnet, in der in dem gezeigten Beispiel gleichzeitig drei Substratkassetten 13 gedreht werden können, sodass eine Substratseite von unten nach oben bzw. umgekehrt gedreht werden kann.

Des Weiteren weist die Substratbearbeitungsanlage 1B aus Figur 3 Substratbrucherkennungen 20 auf, durch welche beschädigte Substrate 3 optisch identifiziert werden können. Wenn ein bruchgefährdetes oder gebrochenes Substrat 3 festgestellt wird, kann dieses fehlerhafte Substrat 3 mittels einer ebenfalls vorhandenen Substratbruchabsaugung sofort entsorgt werden, sodass der Produktionsprozess nur unwesentlich gestört wird. An den Substratbe- und -entladebereichen 2 sind jeweils zwei Kassettenspeicher 19 angeordnet. In den Kassettenspeichern 19 können Substrate 3 zwischengespeichert werden, die beispielsweise bei ungleichen Kapazitäten von Substratträgerkassetten 13 und Trägervorrichtungen 7 anfallen.

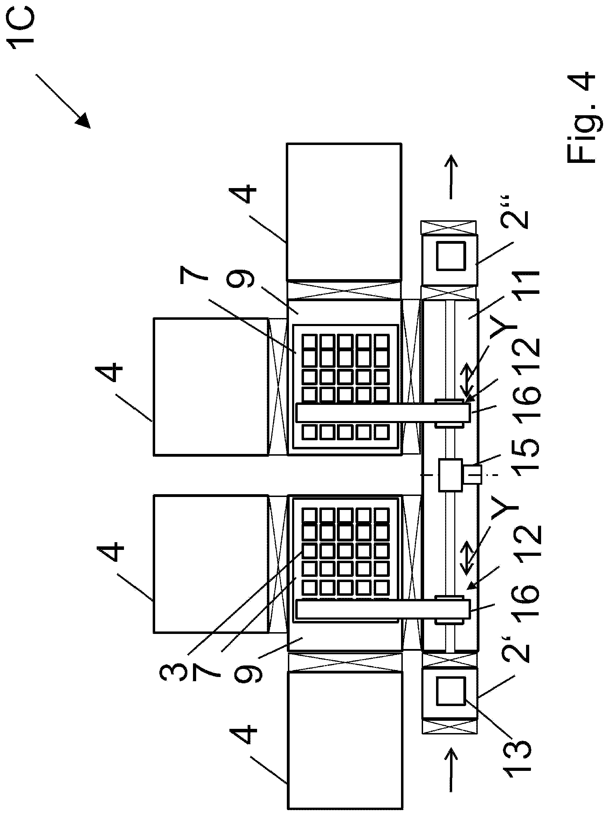

Figur 4 zeigt schematisch eine andere Ausführungsform einer Substratbearbeitungsanlage 1C mit vier Prozessmodulen 4 in einer Draufsicht. In der Variante von Figur 4 weist die Substratbearbeitungsanlage 1C zwei voneinander getrennte Trägertransportbereiche 9 auf, an welchen jeweils ein Prozessmodul 4 in Substratträgerzeilenrichtung X und ein Prozessmodul 4 in Substratträgerspaltenrichtung Y angeordnet ist. In den Trägertransportbereichen 9 befindet sich jeweils eine Trägervorrichtung 7, welche jeweils mittels einer Substratumladevorrichtung 12 mit Substraten 3 bestückbar ist. In dem gezeigten Ausführungsbeispiel ist ein Substratumladebereich 11 vorgesehen, in dem die Umladebrücke 16 der Substratumladevorrichtungen 12 in Substratträgerspaltenrichtung Y der Trägervorrichtungen 7 verschiebbar sind, um alle Substratnester der Trägervorrichtungen 7 mit Substraten 3 belegen bzw. die Substrate 3 von den Substratnestern wieder aufnehmen zu können.

Dabei kann in der Substratbearbeitungsanlage 1C eine Trägervorrichtung 7 mit Substraten 3 entweder nacheinander in beiden Prozessmodulen 4 bearbeitet werden, oder es kommen zwei Trägervorrichtungen 7 zum Einsatz, die in einem Pendelbetrieb betrieben werden, wobei gleichzeitig die Bearbeitung einer mit Substraten 3 beladenen Trägervorrichtung 7 in einem Prozessmodul 4 und ein Umladevorgang auf einer anderen Trägervorrichtung 7 vorgesehen ist.

Die Substrate 3 werden in der Substratbearbeitungsanlage 1C von Figur 4 zunächst in einen Substratbeladebereich 2' eingebracht. In diesem Stadium befinden sich die Substrate 3 noch innerhalb einer Substratkassette 13, in welcher die Substrate 3 in verschiedenen horizontalen Kassettenebenen der Substratkassette 13 angeordnet sind. Die Substratkassette 13 wird nachfolgend nach Durchfahren einer gasdicht verschließbaren Schleuse in den Substratumladebereich 11 eingebracht, wo die Substratkassette 13 entlang der durch die Pfeile in Figur 4 markierten Substratträgerspaltenrichtung Y verfahrbar ist. Dabei werden mittels der Substratumladevorrichtung 12 die in der Substratkassette 13 befindlichen Substrate 3 unter Verwendung der Umladebrücken 16 auf die Trägervorrichtungen 7 verteilt. Wenigstens eine der mit Substraten 3 beladenen Trägervorrichtungen 7 wird nachfolgend mit Hilfe der Trägertransportvorrichtung 8, welche beispielsweise in Figur 2 dargestellt ist, in eines der Prozessmodule 4 eingebracht, um in einer darin befindlichen Prozesskammer verarbeitet werden zu können. Die Bearbeitung kann beispielsweise eine Schichtabscheidung sein, kann jedoch auch eine Plasmabehandlung, ein Ätzschritt, eine Temperaturbehandlung und/oder ein anderer geeigneter Prozessschritt sein.

Nachdem die Bearbeitung einer Substratseite in der Substratbearbeitungsanlage 1C beispielsweise in den zwei links dargestellten Prozessmodulen 4 erfolgt ist, werden die Substrate 3 mittels einer zwischen den beiden Trägertransportbereichen 9 befindlichen Substratkassettendrehvorrichtung 15 gedreht. Anschließend erfolgt eine Bearbeitung der zweiten Substratseite in den anderen beiden, in Figur 4 rechts dargestellten Prozessmodulen 4. Abschließend werden die Substrate 3 in eine Substratkassette 13 umgeladen und aus dem Substratentladebereich 2", der auf der rechten Seite von Figur 4 dargestellt ist, aus der Substratbearbeitungsanlage 1C entladen.

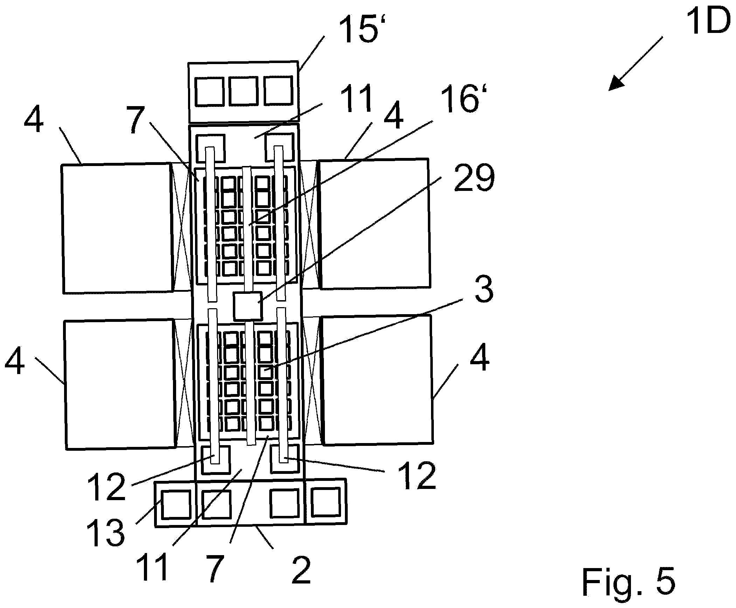

Figur 5 zeigt ein Ausführungsbeispiel einer erfindungsgemäßen Substratbearbeitungsanlage 1D mit vier Prozessmodulen 4 in einer Draufsicht. Bei der Substratbearbeitungsanlage 1D sind parallel zu den Substratträgerzeilen jeweils zwei Prozessmodule 4 beidseitig neben dem Trägertransportbereich 9 angeordnet. Zwei dieser Prozessmodule 4 sind für Vorderseitenbeschichtungen der Substrate 3 vorgesehen, und die anderen beiden der Prozessmodule 4 sind für die Rückseitenbeschichtung nach dem Wenden der Substrate 3 in der Substratkassettendrehvorrichtung 15' bestimmt.

Die Substratbearbeitungsanlage 1D ist keine Durchlaufanlage, sondern die Substrate 3 werden hier über einen einzigen Substratbelade- und -entladebereich 2 beladen und entladen. Dabei werden die Substrate 3, ähnlich wie in den vorgenannten Beispielen, zunächst in einer Substratkassette 13 in die Substratbearbeitungsanlage 1D eingebracht und dann von der Substratkassette 13 unter Verwendung von Substratumladevorrichtungen 12 auf wenigstens eine Trägervorrichtung 7 aufgelegt. Mit Hilfe der Trägervorrichtung 7 können die Substrate 3 dann auf der Trägervorrichtung 7 aufliegend in wenigstens eines der Prozessmodule 4 eingebracht werden, um in einer darin befindlichen Prozesskammer prozessiert werden zu können. Nach erfolgter Bearbeitung der Substrate 3 wird die entsprechende Trägervorrichtung 7 wieder mittels der verwendeten Trägertransportvorrichtung aus dem Prozessmodul 4 heraus transportiert. Daraufhin kann die jeweilige Trägervorrichtung 7 beispielsweise in das auf der anderen Seite des Trägertransportbereiches 9 befindliche Prozessmodul 4, wiederum unter Verwendung der Trägertransportvorrichtung, transportiert werden. In dem anderen Prozessmodul 4 befindet sich ebenfalls eine in Figur 5 nicht gezeigte Prozesskammer, in welcher die Substrate 3 einem weiteren Prozessschritt ausgesetzt werden können. Nach dieser Bearbeitung der Substrate 3 werden diese auf der Trägervorrichtung 7 aufliegend wieder in den Trägertransportbereich 9 überführt und können dann beispielsweise mittels der Substratumladevorrichtungen 12 wieder in entsprechende Substratkassetten 13 eingebracht werden.

Wie es in Figur 5 zu sehen ist, kann zwischen den beiden Trägertransportbereichen 9 eine Substratumladestation 29 zum Umladen der Substrate 3 von einer Trägervorrichtung 7 auf eine andere Trägervorrichtung 7 vorgesehen sein. Die Substratumladestation 29 kann dabei ähnlich wie die oben beschriebene Substratumladevorrichtung 12 aufgebaut sein und damit berührungslos die Substrate 3 von einer Trägervorrichtung 7 aufnehmen, entlang eines Umladearmes bzw. einer Umladebrücke 16' oberhalb der Trägervorrichtungen 7 verfahren und die Substrate 3 dann auf der anderen Trägervorrichtung 7 ablegen.

Bei der Substratbearbeitungsanlage 1D sind entsprechend der hohen Produktionsgeschwindigkeit in vier Prozessmodulen 4 für jede der zwei Trägervorrichtungen 7 in dem Substratumladebereich 11 zwei parallel arbeitende Substratumladevorrichtungen 12 vorgesehen.

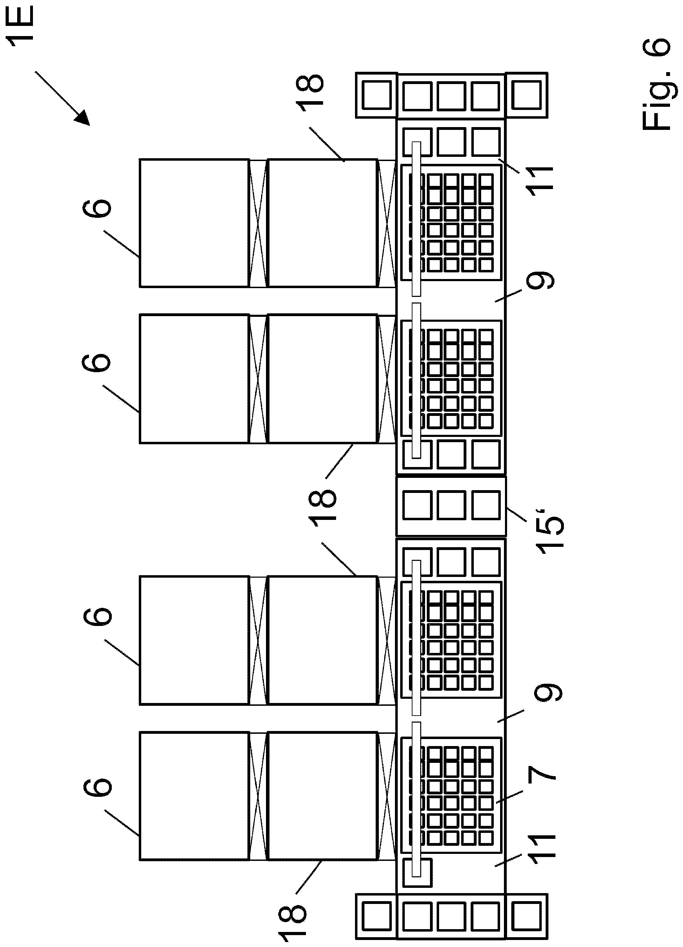

Figur 6 zeigt eine Draufsicht einer weiteren Option einer Substratbearbeitungsanlage 1E, die vier Mehrkammerprozessmodule 6 aufweist. In jedem der Mehrkammerprozessmodule 6 befinden sich in einem vertikalen Stapel zwei Prozesskammern 5 übereinander. In anderen, nicht gezeigten Ausführungsbeispielen der vorliegenden Erfindung können auch mehr als zwei Prozesskammern 5 übereinander in den Mehrkammerprozessmodulen 6 vorgesehen sein. Ferner können einzelne der in Figur 6 dargestellten Mehrkammerprozessmodule 6 auch durch einfache Prozessmodule 5, wie sie beispielsweise in den vorgenannten Figuren dargestellt sind, ersetzt sein.

Zwischen den Trägertransportbereichen 9 und den Mehrkammerprozessmodulen 6 ist jeweils ein Transfermodul 18 angeordnet. Das Transfermodul 18 ist jeweils durch vakuumdichte Tore oder Verschlusseinrichtungen einerseits von dem zugehörigen Mehrkammerprozessmodul 6 und andererseits von dem Trägertransportbereich 9 getrennt. Innerhalb des Transfermoduls 18 kann beispielsweise eine Erwärmung oder Abkühlung von in dem jeweiligen Mehrkammerprozessmodul 6 zu prozessierenden oder bereits prozessierten Substraten 3 vorgenommen werden. Ferner muss in dem Transfermodul 18 eine geeignete Atmosphäre eingestellt werden. Das Transfermodul 18 kann evakuiert werden.

Innerhalb des Transfermoduls 18 kann ein in Figur 6 nicht dargestellter Trägervorrichtungslift vorgesehen sein, mit welchem die jeweilige Trägervorrichtung 7 auf ein Niveau gebracht werden kann, das der jeweiligen Prozesskammer 5 in dem Mehrkammerprozessmodul 6 entspricht, in welchem die auf der Trägervorrichtung 7 aufliegenden Substrate 3 prozessiert werden sollen. Außerdem kann die Trägervorrichtung 7 mittels des Trägervorrichtungsliftes auch auf eine andere Ebene gebracht werden, in welcher die jeweilige Trägervorrichtung 7 beispielsweise an einer anderen Trägervorrichtung 7, welche auf einer anderen Trägervorrichtungsebene transportiert wird, vorbeibewegt werden kann.

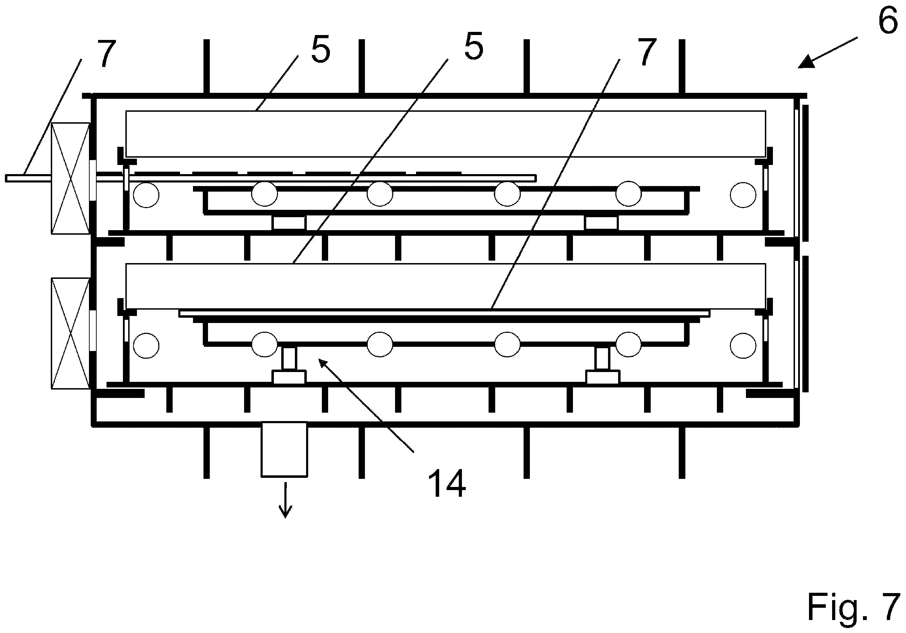

Figur 7 zeigt schematisch einen Querschnitt eines beispielsweise in der Ausführungsform von Figur 6 verwendbaren Mehrkammerprozessmodules 6. In dem hier vorgestellten Ausführungsbeispiel beinhaltet das Mehrkammerprozessmodul 6 zwei vertikal übereinander angeordnete Prozesskammern 5. In anderen, nicht dargestellten Ausführungsvarianten kann das Mehrkammerprozessmodul 6 auch mehr als zwei Prozesskammern 5 aufweisen.

Bei den in Figur 7 vorgestellten Prozesskammern 5 dient die Trägervorrichtung 7 als Boden der Prozesskammer 5. Die obere Trägervorrichtung 7 in Figur 7 ist in einem Zustand während des Transportes auf einem in der Trägertransportvorrichtung 8 verwendeten Rollentransportsystem dargestellt. In diesem Zustand fehlt der Boden der oberen Prozesskammer 5 und die obere Prozesskammer 5 ist offen gegenüber dem Prozessmodul 6. Die untere Trägervorrichtung 7 verschließt hingegen die untere Prozesskammer 5, indem sie von einer Hubvorrichtung 14 gegen die untere Prozesskammer 5 gedrückt wird. Das Mehrkammerprozessmodul 6 ist eine abschließbare Kammer, die gegenüber der Umwelt und gegenüber benachbarten Modulen der Substratbearbeitungsanlage 1E verschließbar ist.

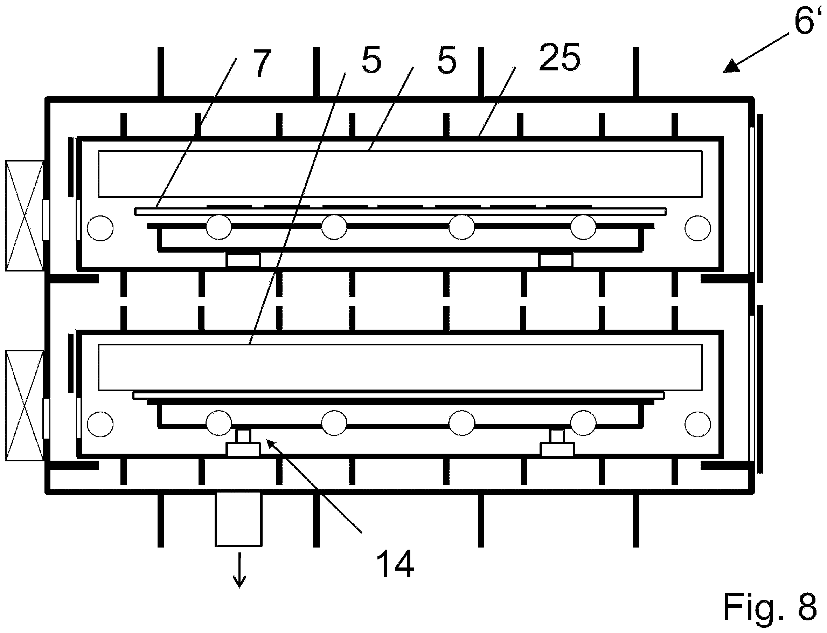

Figur 8 zeigt schematisch einen Querschnitt eines weiteren, in der Substratbearbeitungsanlage 1E von Figur 6 einsetzbaren Mehrkammerprozessmodules 6'. Das Prozessmodul 6' enthält im Unterschied zu dem Prozessmodul 6, das in Figur 7 gezeigt ist, für jede der Prozesskammern 5 eine verschließbare Isolierkammer 25. Die verschließbare Isolierkammer 25 kann beispielsweise als zusätzliche Isolierstufe zur besseren thermischen und chemischen Entkopplung der Prozesskammer 5 von der Außenatmosphäre vorgesehen sein. In einem anderen Anwendungsfall kann die Isolierkammer 25 auch als Hilfsvorrichtung für einen Reinigungsprozess der Prozesskammer 5 vorgesehen sein, bei welchem in einer geschlossenen Isolierkammer 25 eine abgesenkte Trägervorrichtung 7 bei geöffneter Prozesskammer 5 durch ein Ätzplasma gereinigt wird. In der abgesenkten Stellung der Trägervorrichtung 7 werden im Gegensatz zu einer geschlossenen Prozesskammer 5 auch die Randbereiche der Trägervorrichtung 7 mit gereinigt. Die Isolierkammer 25 verhindert dabei die Ausbreitung von Reinigungsgasen in das Prozessmodul 6'.

Die Prozesskammern 5 enthalten dabei bevorzugt eine oder mehrere Vorrichtungen zur Erzeugung von Plasma. Eine solche bevorzugte Vorrichtung kann z. B. eine planare RF-Elektrode sein, die als Gasdusche ausgeführt ist. In diesem Fall bildet die Trägervorrichtung 7 die Gegenelektrode einer Parallel-Plattenanordnung. Die Prozesskammern 5 enthalten dann auch alle notwendigen Medienversorgungsanschlüsse wie Pumpanschlüsse, elektrische Versorgungsanschlüsse, Gasversorgungsanschlüsse und Vorrichtungen zur Temperierung.

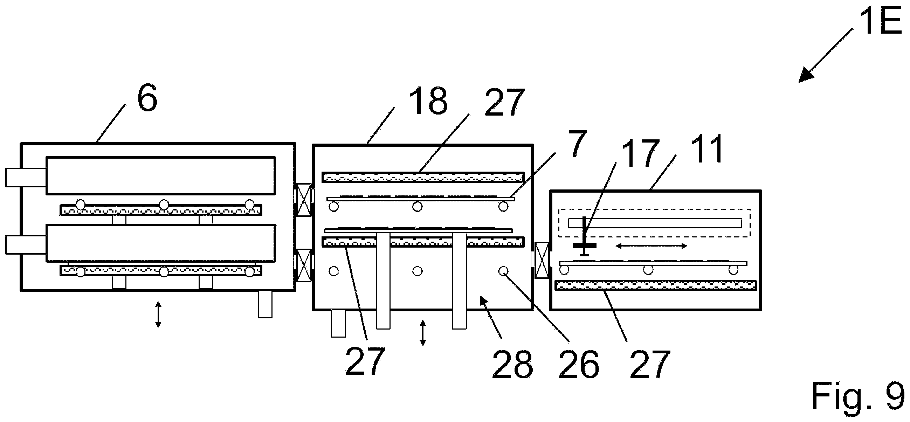

Figur 9 zeigt schematisch einen Querschnitt einer Substratbearbeitungsanlage 1E mit einem Mehrkammerprozessmodul 6. Das Mehrkammerprozessmodul 6 kann beispielsweise wie in Figur 7 aufgebaut sein. Auf obige Beschreibung sei verwiesen. In Figur 9 ist ein Ausführungsbeispiel eines Transfermoduls 18 detaillierter dargestellt. In dem gezeigten Transfermodul 18 sind zwei Transportebenen für Trägervorrichtungen 7 vorhanden, die durch die skizzierten Transportrollen 26 markiert sind. Von den beiden Transportebenen in dem Transfermodul 18 können die Trägervorrichtungen 7 in die beiden Transportebenen des Mehrkammerprozessmodules 6 transportiert werden. Mit einem Trägervorrichtungslift 28 können die Trägervorrichtungen 7 zwischen den beiden Transportebenen verfahren werden. Die Transportrollen 26 können dabei in Richtung ihrer Achsen bewegt werden, um den erforderlichen Raum für eine Hubbewegung der Trägervorrichtung 7 frei zu geben. Das Transfermodul 18 weist zudem wenigstens eine Heiz- und/oder Kühlvorrichtung, wie beispielsweise eine Heizplatte, eine Strahlungsheizung und/oder ein Kühlaggregat, zum Heizen und/oder Kühlen der Trägervorrichtung 7 auf. Das Transfermodul 18 ist dem Trägertransportbereich 9 zuzuordnen und stellt somit eine Verbindung zwischen dem Substratumladebereich 11 und dem Mehrkammerprozessmodul 6 her.

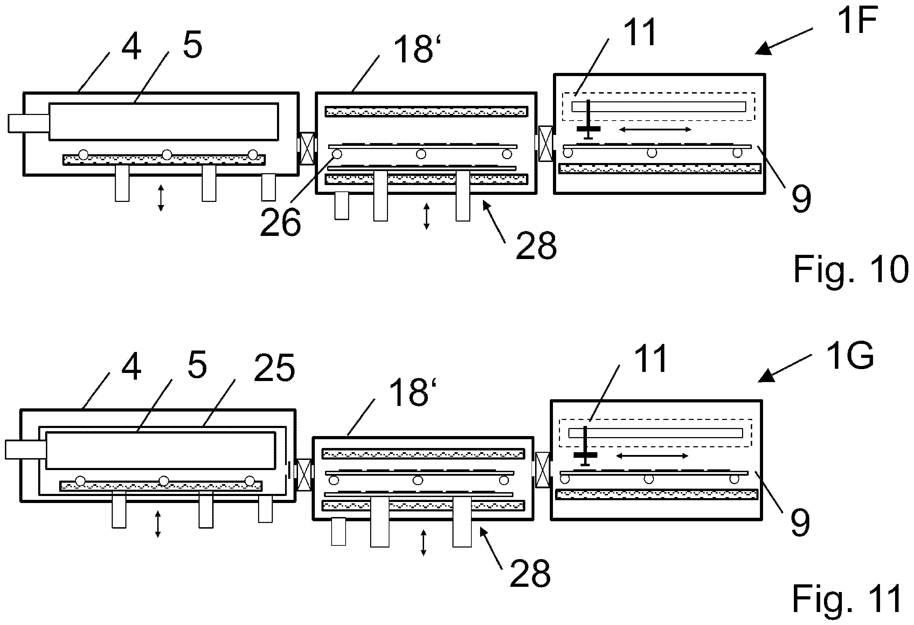

Die Figuren 10 und 11 zeigen schematisch Querschnitte von Substratbearbeitungsanlagen 1F und 1G. Die Substratbearbeitungsanlagen 1F und 1G weisen Prozessmodule 4 auf, die jeweils eine Prozesskammer 5 enthalten. Die Substratbearbeitungsanlage 1G weist im Unterschied zur Substratbearbeitungsanlage 1F eine Isolierkammer 25 zum Einschluss der Prozesskammer 5 auf. Beide Substratbearbeitungsanlagen 1F und 1G weisen ein Transfermodul 18' auf, das jeweils nur eine, durch die dargestellten Transportrollen 26 ersichtliche Transportebene aufweist. Die Transfermodule 18' sind zur Handhabung von zwei Trägervorrichtungen 7 konzipiert. Während sich die eine Trägervorrichtung 7 in der Transportebene befindet, kann eine zweite Trägervorrichtung 7 auf einem Trägervorrichtungslift 28 zwischengespeichert werden. Durch dieses Zwischenspeichern ist es möglich, Wartezeiten von Trägervorrichtungen 7 in dem Trägertransportbereich 9 zu minimieren. Generell können aber auch weitere Plätze im Trägervorrichtungslift 28 als Zwischenspeicher vorgesehen werden.

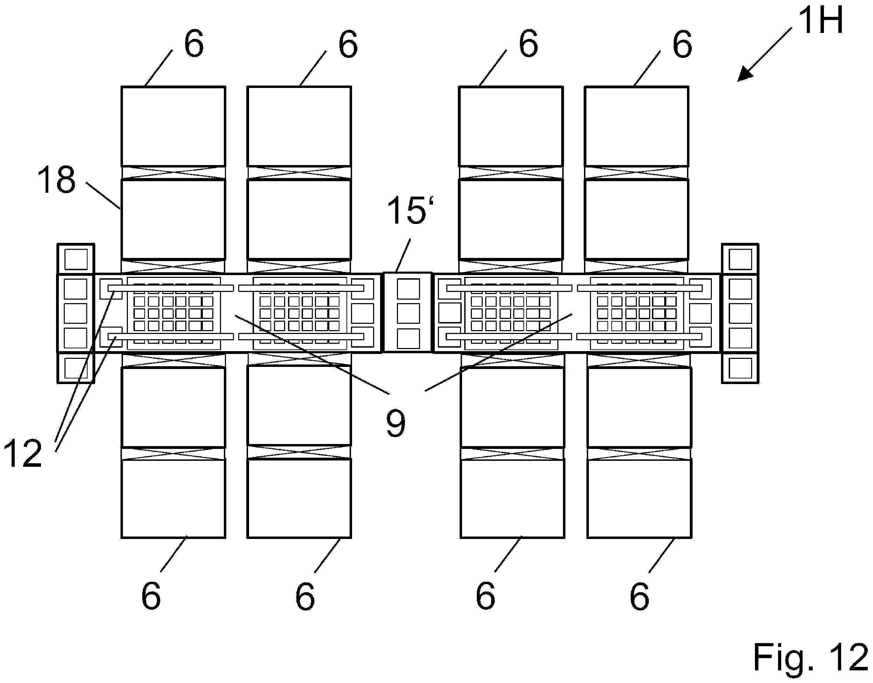

Figur 12 zeigt schematisch eine weitere Substratbearbeitungsanlage 1H, die acht Mehrkammerprozessmodule 6 aufweist. Die Substratbearbeitungsanlage 1H weist entsprechend 16 Prozesskammern auf und verfügt über einen entsprechend hohen Produktionsdurchsatz. Die Trägertransportbereiche 9 sind in dem dargestellten Ausführungsbeispiel jeweils mit vier Substratumladevorrichtungen 12 gekoppelt, um den hohen logistischen Anforderungen in dieser Substratbearbeitungsanlage 1H gerecht zu werden.

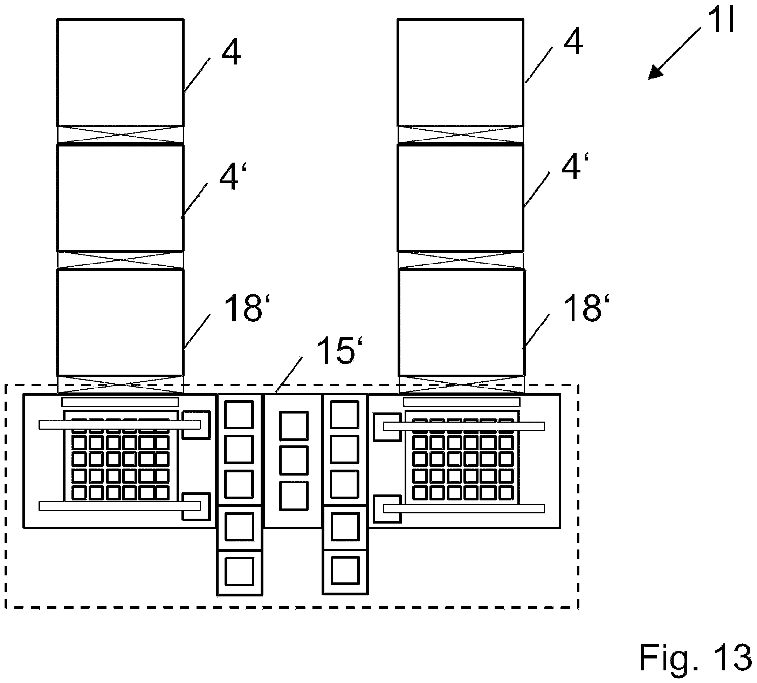

In Figur 13 ist schematisch eine weitere Ausführungsform einer Substratbearbeitungsanlage 1I in einer Draufsicht dargestellt. Die Substratbearbeitungsanlage 1I weist zwei lineare Anreihungen eines Transfermodules 18', eines Prozessmodules 4' und eines Prozessmodules 4 auf. Das Prozessmodul 4' ist dabei zweiseitig mit verschließbaren Durchgängen zum Durchgang von Trägervorrichtungen 7 ausgestattet. Die lineare Anreihung von Prozessmodulen 4, 4' ist eine relativ einfache Möglichkeit für den Ausbau erfindungsgemäßer Substratbearbeitungsanlagen. Ein Nachteil, der bei der linearen Anreihung von Prozessmodulen 4, 4' in Kauf genommen werden muss, ist der erhöhte logistische Aufwand bei dem Transport der Trägervorrichtungen 7.

Vorteilhaft ist es, wenn in den Transfermodulen 18, 18' mehrere Ebenen für Trägervorrichtungen 7 enthalten sind. Bei einem Schleusenvorgang können dann entweder gleichzeitig oder nacheinander mehrere Trägervorrichtungen 7 zwischen Atmosphäre und Vakuum ausgetauscht werden und damit die Anzahl anfallender Belüftungen bzw. Evakuierungen des Transfermoduls 18, 18' reduziert werden.

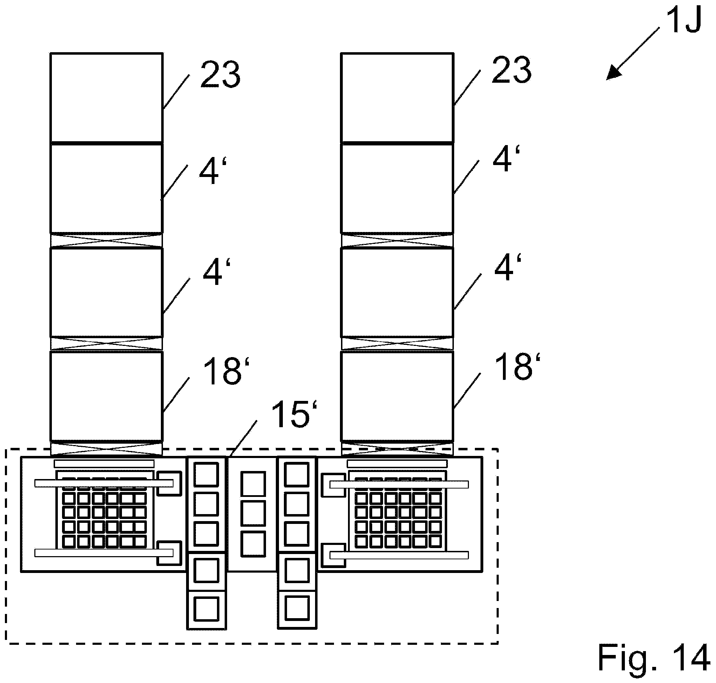

Eine andere Substratbearbeitungsanlage 1J mit linearen Anreihungen von Prozessmodulen 4' ist in Figur 14 gezeigt. Die Substratbearbeitungsanlage 1J ist gegenüber der Substratbearbeitungsanlage 1I durch Trägervorrichtungsspeicher 23 weitergebildet, die an die äußeren Prozessmodule 4' gekoppelt sind. Die Trägervorrichtungsspeicher 23 können Trägervorrichtungen 7 zwischenspeichern und dadurch logistische Wartezeiten beim Transport von Trägervorrichtungen 7 reduzieren.

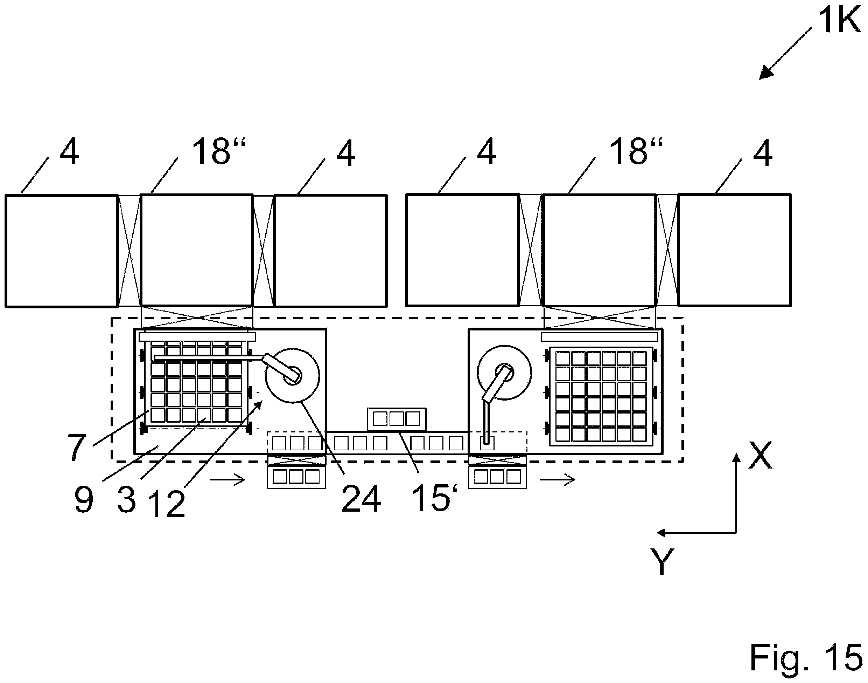

In Figur 15 ist eine weitere Option einer Substratbearbeitungsanlage 1K schematisch in einer Draufsicht dargestellt. Anhand der Substratbearbeitungsanlage 1 K sind weitere Ausführungsoptionen für Substratbearbeitungsanlagen veranschaulicht. Vorliegend ist die Substratumladevorrichtung 12 nicht in Form einer Umladebrücke sondern durch einen Umladeroboter 24 ausgebildet. Der Umladeroboter 24 weist einen verdrehbaren und linear ausfahrbaren Roboterarm auf, der alle Substrate 3 auf einer Trägervorrichtung 7 erreichen kann. Des Weiteren weist die Substratbearbeitungsanlage 1K zwei Transfermodule 18" auf, welche einen Trägervorrichtungslift 28 und einen Puffer für Trägervorrichtungen 7 aufweisen. Das Transfermodul 18" ermöglicht den Transport von Trägervorrichtungen 7 sowohl in Substratträgerzeilenrichtung X als auch in Substratträgerspaltenrichtung Y. In der Substratbearbeitungsanlage 1K sind an den Transfermodulen 18" in der Substratspaltenrichtung Y jeweils zwei Prozessmodule 4 angeordnet. Die Trägertransportbereiche 9 sind hingegen an den Transfermodulen 18" entlang der Substratträgerzeilenrichtung X angeordnet. Die Prozessmodule 4 können auch als Mehrkammerprozessmodule ausgeführt sein. Diese Ausführungsform kann generell auch auf die nachfolgend beschriebenen Varianten von Substratbearbeitungsanlagen in Kombination mit Transfermodulen 18" angewendet werden. Vorteilhaft kann es auch sein, wenn in den Trägertransportbereichen 9 auch weitere Roboter, zum Beispiel zur Erhöhung des Substratdurchsatzes bzw. auch zur Substratbruchbeseitigung, eingesetzt werden.

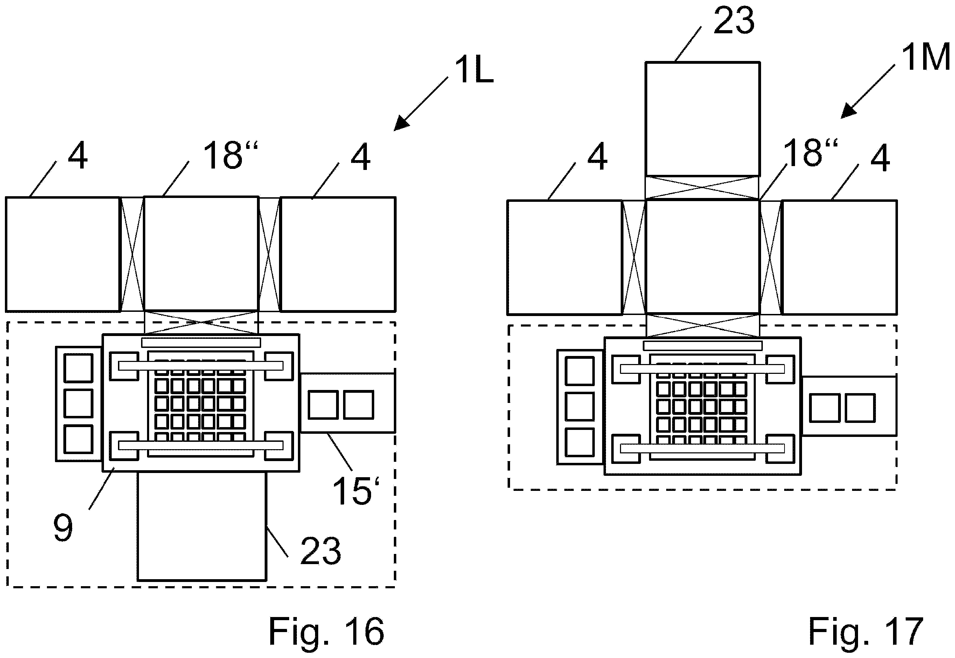

In den Figuren 16 und 17 sind weitere Ausführungsmöglichkeiten von Substratbearbeitungsanlagen 1L und 1M schematisch in Draufsichten gezeigt. Die Substratbearbeitungsanlage 1L demonstriert eine Ausgestaltung, bei welcher ein Trägervorrichtungsspeicher 23 direkt mit einem Trägertransportbereich 9 gekoppelt ist. Die Substratbearbeitungsanlage 1M veranschaulicht hingegen die Option, an das Transfermodul 18" einen Trägervorrichtungsspeicher 23 zu koppeln.

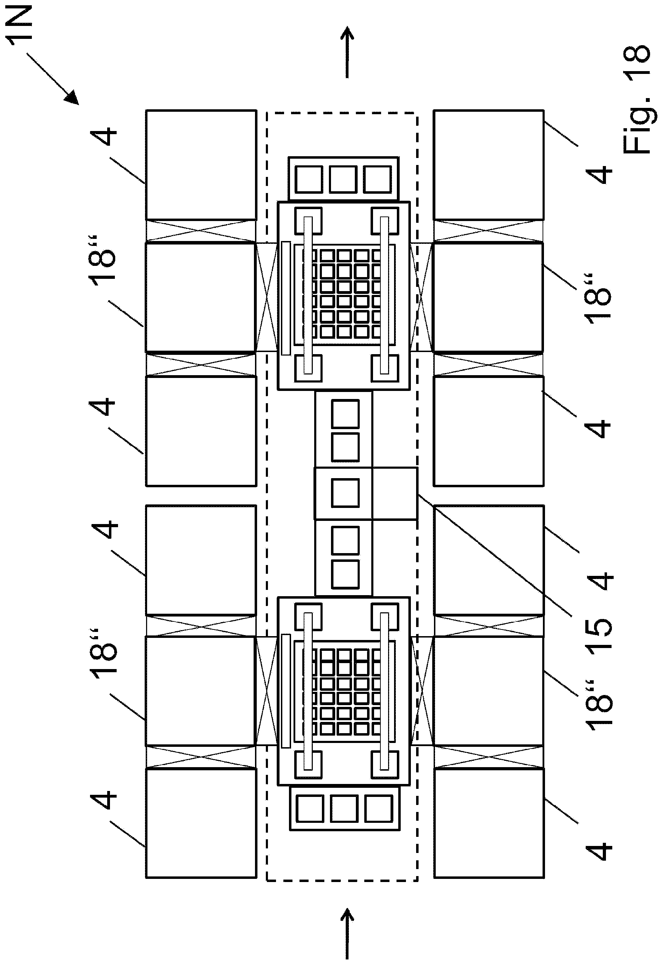

Figur 18 stellt schematisch eine andere Substratbearbeitungsanlage 1N in einer Draufsicht dar. Die Substratbearbeitungsanlage 1N ist eine Durchlaufanlage, die quer zu der Durchlaufrichtung der Substrate 3 durch die Substratbearbeitungsanlage 1N eine relativ geringe Breite aufweist. Die geringe Breite wird durch die Anordnung der Prozessmodule 4 in Substratträgerspaltenrichtung Y an den Transfermodulen 18" erreicht.

Die dargestellten Ausführungsbeispiele zeigen, dass erfindungsgemäße Substratbearbeitungsanlagen 1, 1A bis 1N sehr unterschiedlich ausgebildet sein können. Neben den gezeigten Ausführungsbeispielen sind weitere, hier nicht dargestellte Ausführungsformen oder Kombinationen der gezeigten Ausführungsbeispiele möglich, die der einschlägige Fachmann auf Grundlage der vorliegenden Beschreibung und seiner Fachkenntnisse ohne Weiteres ausbilden kann.

## Patentansprüche

1. Substratbearbeitungsanlage (1, 1A bis 1N), welche
wenigstens einen Substratbelade- und -entladebereich (2) zum Be- und Entladen der Substratbearbeitungsanlage (1) mit wenigstens einem Substrat (3),
wenigstens eine evakuierbare Prozesskammer (5),
wenigstens eine Trägervorrichtung (7), mit welcher das wenigstens eine Substrat (3) mittels wenigstens einer Trägertransportvorrichtung (8) in wenigstens einem Trägertransportbereich (9) zu der wenigstens einen Prozesskammer (5) transportierbar ist, und
wenigstens eine gasdichte Verschlusseinrichtung (10) zwischen der wenigstens einen Prozesskammer (5) und dem Trägertransportbereich (9) aufweist, wobei der Substratbelade- und -entladebereich (2) mit dem Trägertransportbereich (9) durch einen Substratumladebereich (11) mit wenigstens einer Substratumladevorrichtung (12) zum Umladen des wenigstens einen Substrates (3) von wenigstens einer in dem Substratbelade- und -entladebereich (2) vorsehbaren Substratkassette (13), in welcher Substrate (3) in verschiedenen horizontalen Kassettenebenen der Substratkassette (13) anordenbar sind, auf die wenigstens eine Trägervorrichtung (7), mit der das wenigstens eine Substrat (3) in einer horizontalen Trägerebene haltbar ist, gekoppelt ist, wobei die Trägervorrichtung (7) dann, wenn sie sich in dem Substratumladebereich (11) befindet, in dem mittels der Substratumladevorrichtung (12) ein Umladen von Substraten (3) zwischen der Substratkassette (13) und der Trägervorrichtung (7) erfolgt, in dem Trägertransportbereich (9) vorgesehen ist, durch den die Trägertransportvorrichtung (8) für die Trägervorrichtung (7) verläuft;
**dadurch gekennzeichnet,**
**dass** die Substratbearbeitungsanlage (1, 1A bis 1N) wenigstens eine gasdichte Verschlusseinrichtung (10) zwischen dem Substratbelade- und -entladebereich (2) und dem Trägertransportbereich (9) aufweist und der Substratumladebereich (11) gegenüber dem Substratbelade- und entladebereich (2) gasdicht verschliessbar ist; die Substratbearbeitungsanlage (1, 1A bis 1N) wenigstens zwei der Trägervorrichtungen (7) und wenigstens zwei der Trägertransportbereiche (9) aufweist, zwischen welchen eine Substratumladestation (29) zum Umladen der Substrate (3) von einer der Trägervorrichtungen (7) auf eine andere der Trägervorrichtungen (7) vorgesehen ist, wobei der Substratumladebereich (11) mit Inertgas befüllbar ist oder mit Vakuum oder mit einem reaktiven Gas gefüllt ist.

2. Substratbearbeitungsanlage nach Anspruch 1, **dadurch gekennzeichnet, dass** die Trägervorrichtung (7) in der Trägerebene in Substratträgerzeilen und Substratträgerspalten angeordnete Substratnester aufweist und die Trägervorrichtung (7) in Substratträgerzeilenrichtung (X) und/oder in Substratträgerspaltenrichtung (Y) bewegbar ist.

3. Substratbearbeitungsanlage nach wenigstens einem der vorhergehenden Ansprüche, **dadurch gekennzeichnet, dass** die Substratumladevorrichtung (12) wenigstens eine ultraschallgestützte Substrat-Handhabungsvorrichtung (17) aufweist.

4. Substratbearbeitungsanlage nach wenigstens einem der vorhergehenden Ansprüche, **dadurch gekennzeichnet, dass** die Substratbearbeitungsanlage (1) wenigstens zwei Trägervorrichtungsebenen aufweist, wobei in den Trägervorrichtungsebenen befindliche Trägervorrichtungen (7) unabhängig voneinander bewegbar sind, wobei zwischen wenigstens zwei der Trägervorrichtungsebenen ein Trägervorrichtungslift (28) vorgesehen ist, mit welchem wenigstens eine Trägervorrichtung (7) in eine andere Trägervorrichtungsebene bringbar ist.

5. Substratbearbeitungsanlage nach wenigstens einem der vorhergehenden Ansprüche, **dadurch gekennzeichnet, dass** die Substratbearbeitungsanlage (1, 1A bis 1N) wenigstens zwei mit dem Trägertransportbereich (9) gekoppelte, übereinander angeordnete Prozesskammern (5) aufweist.

6. Substratbearbeitungsanlage nach wenigstens einem der vorhergehenden Ansprüche, **dadurch gekennzeichnet, dass** der Substratbelade- und -entladebereich (2) einen Kassettenspeicher (19) aufweist, in welchem wenigstens eine Substratkassette (3) vorsehbar und bei Bedarf mit der Substratumladevorrichtung (12) koppelbar ist, wobei der Kassettenspeicher (19) evakuierbar und/oder mit Inertgas befüllbar ist.

7. Substratbearbeitungsanlage nach wenigstens einem der vorhergehenden Ansprüche, **dadurch gekennzeichnet, dass** der Trägertransportbereich (9) wenigstens eine Temperierungsvorrichtung aufweist.

8. Substratbearbeitungsanlage nach wenigstens einem der vorhergehenden Ansprüche, **dadurch gekennzeichnet, dass** die Substratbearbeitungsanlage (1, 1A bis 1N) eine Substratwendevorrichtung aufweist, wobei die Substratwendeeinrichtung eine Substratkassettendrehvorrichtung (15) ist.

9. Substratbearbeitungsanlage nach wenigstens einem der vorhergehenden Ansprüche, **dadurch gekennzeichnet, dass** die Substratbearbeitungsanlage (1, 1A bis 1N) eine Substratbrucherkennung (20) und/oder eine Substratbruchbeseitigungsvorrichtung (21) aufweist.

10. Substratbearbeitungsanlage nach wenigstens einem der vorhergehenden Ansprüche, **dadurch gekennzeichnet, dass** wenigstens eine der Prozesskammern (5) durch die Trägervorrichtung (7) gegenüber einem Prozessmodul (4, 6, 6'), in dem diese Prozesskammer (5) vorgesehen ist, körperlich abschließbar ist.

11. Substratbearbeitungsanlage nach wenigstens einem der vorhergehenden Ansprüche, **dadurch gekennzeichnet, dass** die Substratbearbeitungsanlage (1, 1A bis 1N) wenigstens ein Prozessmodul (4, 4', 6, 6') mit jeweils wenigstens einer Prozesskammer (5) aufweist, wobei zwischen dem wenigstens einen Prozessmodul (4, 4', 6, 6') und dem Trägertransportbereich (9) jeweils ein Transfermodul (18, 18', 18") vorgesehen ist, welches gegenüber dem Prozessmodul (4, 4', 6, 6') und gegenüber dem Trägertransportbereich (9) gasdicht verschließbar ist.

12. Substratbearbeitungsanlage nach Anspruch 11, **dadurch gekennzeichnet, dass** in dem Transfermodul (18, 18', 18") wenigstens zwei Ebenen für Trägervorrichtungen (7) vorgesehen sind.

13. Substratbearbeitungsanlage nach wenigstens einem der vorhergehenden Ansprüche, **dadurch gekennzeichnet, dass** die Substratbearbeitungsanlage (1, 1A bis 1N) wenigstens zwei Prozessmodule (4, 4', 6, 6') mit jeweils wenigstens einer Prozesskammer (5) aufweist, wobei jedem Prozessmodul (4, 4', 6, 6') eine eigene Trägervorrichtung (7) zugeordnet ist, wobei der Trägertransportbereich (9) einen Trennbereich für die Prozessmodule (4, 4', 6, 6') und einen Austauschbereich für Substrate (3) auf jeweils andere Trägervorrichtungen (7) bildet.

## Claims

1. Substrate treatment system (1, 1A to 1N), which comprises
at least one substrate loading and unloading region (2) for loading and unloading the substrate treatment system (1) with at least one substrate (3),
at least one process chamber (5) that can be evacuated,
at least one carrier device (7) by means of which the at least one substrate (3) can be transported to the at least one process chamber (5) by means of at least one carrier transport device (8) into at least one carrier transport region (9),
and at least one gas-tight locking device (10) between the at least one process chamber (5) and the carrier transport region (9), the substrate loading and unloading region (2) being coupled to the carrier transport region (9) by a substrate transfer region (11) having at least one substrate transfer device (12) for transferring the at least one substrate (3) from at least one substrate cassette (13), which can be provided in the substrate loading and unloading region (2) and in which substrates (3) can be arranged in different horizontal cassette planes of the substrate cassette (13), to the least one carrier device (7), by means of which the at least one substrate (3) can be held in a horizontal carrier plane, and the carrier device (7), when it is located in the substrate transfer region (11) in which the substrate transfer device (12) is used to transfer substrates (3) between the substrate cassette (13) and the carrier device (7), being provided in the carrier transport region (9) through which the carrier transport device (8) for the carrier device (7) extends;
**characterized in that**
the substrate treatment system (1, 1A to 1N) comprises at least one gas-tight locking device (10) between the substrate loading and unloading region (2) and the carrier transport region (9) and the substrate transfer region (11) can be locked in a gas-tight manner with respect to the substrate loading and unloading region (2);
the substrate treatment system (1, 1A to 1N) comprises at least two of the carrier devices (7) and at least two of the carrier transport regions (9), between which a substrate transfer station (29) is provided for transferring the substrates (3) from one of the carrier devices (7) to another of the carrier devices (7), the substrate transfer area (11) being fillable with inert gas or being filled with vacuum or with a reactive gas.

2. Substrate treatment system according to claim 1, **characterized in that** the carrier device (7) comprises, in the carrier plane, substrate nests being arranged in substrate carrier rows and substrate carrier columns and the carrier device (7) is movable in the substrate carrier row direction (X) and/or in the substrate carrier column direction (Y).

3. Substrate treatment system according to at least one of the preceding claims, **characterized in that** the substrate transfer device (12) comprises at least one ultrasound-assisted substrate handling device (17).

4. Substrate treatment system according to at least one of the preceding claims, **characterized in that** the substrate treatment system (1) comprises at least two carrier device planes, with carrier devices (7) located inside the carrier device planes being movable independently of one another, a carrier device lift (28) being provided between at least two of the carrier device planes, by means of which lift at least one carrier device (7) can be brought into another carrier device plane.

5. Substrate treatment system according to at least one of the preceding claims, **characterized in that** the substrate treatment system (1, 1A to 1N) comprises at least two process chambers (5) which are coupled to the carrier transport region (9) and are arranged one above the other.

6. Substrate treatment system according to at least one of the preceding claims, **characterized in that** the substrate loading and unloading region (2) comprises a cassette store (19) in which at least one substrate cassette (3) can be provided and, if necessary, can be coupled to the substrate transfer device (12), it being possible for the cassette store (19) to be evacuated and/or filled with inert gas.

7. Substrate treatment system according to at least one of the preceding claims, **characterized in that** the carrier transport region (9) comprises at least one temperature-control device.

8. Substrate treatment system according to at least one of the preceding claims, **characterized in that** the substrate treatment system (1, 1A to 1N) comprises a substrate turning device, the substrate turning device being a substrate cassette rotating device (15).

9. Substrate treatment system according to at least one of the preceding claims, **characterized in that** the substrate treatment system (1, 1A to 1N) comprises a substrate breakage detection means (20) and/or a substrate breakage removal device (21).

10. Substrate treatment system according to at least one of the preceding claims, **characterized in that** at least one of the process chambers (5) can be physically locked by the carrier device (7) with respect to a process module (4, 6, 6') in which this process chamber (5) is provided.

11. Substrate treatment system according to at least one of the preceding claims, **characterized in that** the substrate treatment system (1, 1A to 1N) comprises at least one process module (4, 4', 6, 6') with at least one process chamber (5) each, a transfer module (18, 18', 18") being provided between the at least one process module (4, 4', 6, 6') and the carrier transport region (9), which transfer module can be locked in a gas-tight manner with respect to the process module (4, 4', 6, 6') and with respect to the carrier transport region (9).

12. Substrate treatment system according to claim 11, **characterized in that** at least two planes for carrier devices (7) are provided in the transfer module (18, 18', 18").

13. Substrate treatment system according to at least one of the preceding claims, **characterized in that** the substrate treatment system (1, 1A to 1N) comprises at least two process modules (4, 4', 6, 6') each having at least one process chamber (5), with each process module (4, 4', 6, 6') being assigned its own carrier device (7), the carrier transport region (9) forming a separation region for the process modules (4, 4', 6, 6') and a region for exchanging substrates (3) onto other carrier devices (7).

## Revendications

1. Installation de traitement de substrat (1, 1A à 1N), laquelle présente
au moins une zone de charge et de décharge de substrat (2) servant à charger et à décharger l'installation de traitement de substrat (1) avec au moins un substrat (3),
au moins une chambre de processus (5) pouvant être évacuée,
au moins un dispositif de support (7) à l'aide duquel l'au moins un substrat (3) peut être transporté dans au moins une zone de transport de support (9) vers l'au moins une chambre de processus (5) au moyen d'au moins un dispositif de transport de support (8), et
au moins un dispositif de fermeture (10) étanche aux gaz entre l'au moins une chambre de processus (5) et la zone de transport de support (9), la zone de charge et de décharge de substrat (2) étant accouplée à la zone de transport de support (9) par une zone de transfert de substrat (11) avec au moins un dispositif de transfert de substrat (12) servant à transférer l'au moins un substrat (3) depuis au moins une cassette de substrat (13), laquelle peut être prévue dans la zone de charge et de décharge de substrat (2) et dans laquelle les substrats (3) peuvent être disposés dans différents plans horizontaux de la cassette de substrat (13), vers l'au moins un dispositif de support (7) au moyen duquel l'au moins un substrat (3) peut être maintenu dans un plan de support horizontal,
le dispositif de support (7), lorsqu'il est situé dans la zone de transfert de substrat (11) dans laquelle un transfert de substrats (3) se produit entre la cassette de substrat (13) et le dispositif de support (7) au moyen du dispositif de transfert de substrat (12), étant prévu dans la zone de transport de support (9), à travers laquelle s'étend le dispositif de transport de support (8) destiné au dispositif de support (7) ;
**caractérisée en ce**
**que** l'installation de traitement de substrat (1, 1A à 1N) présente au moins un dispositif de fermeture (10) étanche aux gaz entre la zone de charge et de décharge de substrat (2) et la zone de transport de support (9) et la zone de transfert de substrat (11) peut être fermée de manière étanche aux gaz par rapport à la zone de charge et de décharge de substrat (2) ; l'installation de traitement de substrat (1, 1A à 1N) comprenant au moins deux des dispositifs de support (7) et au moins deux des zones de transport de support (9), entre lesquels est prévue une station de transfert de substrat (29) servant à transférer les substrats (3) depuis l'un des dispositifs de support (7) vers un autre des dispositifs de support (7), la zone de transfert de substrat (11) pouvant être remplie de gaz inerte ou étant remplie de vide ou d'un gaz réactif.

2. Installation de traitement de substrat selon la revendication 1, **caractérisée en ce que** le dispositif de support (7) présente des nids de substrat disposés dans des lignes de support de substrat et dans des colonnes de support de substrat sur le plan de support et **en ce que** le dispositif de support (7) peut être déplacé dans le sens de ligne de support de substrat (X) et/ou dans le sens de colonnes de support de substrat (Y).

3. Installation de traitement de substrat selon au moins l'une des revendications précédentes, **caractérisée en ce que** le dispositif de transfert de substrat (12) présente au moins un dispositif de manipulation de substrat assisté par ultrasons (17).

4. Installation de traitement de substrat selon au moins l'une des revendications précédentes, **caractérisée en ce que** l'installation de traitement de substrat (1) présente au moins deux plans de dispositif de support, des dispositifs de support (7) situés sur les plans de dispositif de support étant mobiles indépendamment les uns des autres, un élévateur de dispositif de support (28) étant prévu entre au moins deux des plans de dispositif de support, au moyen duquel au moins un dispositif de support (7) peut être amené dans un autre plan de dispositif de support.

5. Installation de traitement de substrat selon au moins l'une des revendications précédentes, **caractérisée en ce que** l'installation de traitement de substrat (1, 1A à 1N) présente au moins deux chambres de processus (5), lesquelles sont accouplées à la zone de transport de support (9) et disposées l'une au-dessus de l'autre.

6. Installation de traitement de substrat selon au moins l'une des revendications précédentes, **caractérisée en ce que** la zone de charge et de décharge de substrat (2) présente un stockage de cassette (19) dans lequel au moins une cassette de substrat (3) peut être prévue et, si nécessaire, peut être accouplé au dispositif de transfert de substrat (12), le stockage de cassette (19) pouvant être évacué et/ou rempli de gaz inerte.

7. Installation de traitement de substrat selon au moins l'une des revendications précédentes, **caractérisée en ce que** la zone de transport de support (9) présente au moins un dispositif de régulation de température.

8. Installation de traitement de substrat selon au moins l'une des revendications précédentes, **caractérisée en ce que** l'installation de traitement de substrat (1, 1A à 1N) présente un dispositif de retournement de substrat, le dispositif de retournement de substrat étant un dispositif de rotation de cassette de substrat (15).

9. Installation de traitement de substrat selon au moins l'une des revendications précédentes, **caractérisée en ce que** l'installation de traitement de substrat (1, 1A à 1N) présente une détection de rupture de substrat (20) et/ou un dispositif de réparation de rupture de substrat (21).

10. Installation de traitement de substrat selon au moins l'une des revendications précédentes, **caractérisée en ce qu'**au moins l'une des chambres de processus (5) peut être physiquement fermée par le dispositif de support (7) par rapport à un module de processus (4, 6, 6') dans lequel cette chambre de processus (5) est prévue.

11. Installation de traitement de substrat selon au moins l'une des revendications précédentes, **caractérisée en ce que** l'installation de traitement de substrat (1, 1A à 1N) présente au moins un module de processus (4, 4', 6, 6') comportant respectivement au moins une chambre de processus (5), un module de transfert (18, 18' 18") étant respectivement prévu entre l'au moins un module de processus (4, 4', 6, 6') et la zone de transport de support (9), lequel module de transfert peut être fermé de manière étanche aux gaz par rapport au module de processus (4, 4', 6, 6') et par rapport à la zone de transport de support (9).

12. Installation de traitement de substrat selon la revendication 11, **caractérisée en ce qu'**au moins deux plans pour les dispositifs de support (7) sont prévus dans le module de transfert (18, 18', 18").

13. Installation de traitement de substrat selon au moins l'une des revendications précédentes, **caractérisée en ce que** l'installation de traitement de substrat (1, 1A à 1N) présente au moins deux modules de processus (4, 4', 6, 6') comportant respectivement au moins une chambre de processus (5), un dispositif de support (7) étant associé respectivement à chaque module de processus (4, 4', 6, 6'), la zone de transport de support (9) formant une zone de séparation pour les modules de processus (4, 4', 6, 6') et une zone d'échange pour les substrats (3) vers d'autres dispositifs de support (7) respectivement.
